# EUROPÄISCHE PATENTSCHRIFT

(11) **EP 2 948 502 B1**
(45) Veröffentlichungstag und Bekanntmachung des Hinweises auf die Patenterteilung: **06.12.2017**
(21) Anmeldenummer: 14737138.9
(22) Anmeldetag: 16.01.2014
(51) Int. Cl.: C08K 3/00, C09K 21/02, C04B 18/04

(54) **MODIFIZIERTER KARBONISIERTER ROTSCHLAMM**
MODIFIED CARBONIZED RED MUD
BOUE ROUGE MODIFIÉE CARBONISÉE

(30) Priorität: 22.01.2013 DE 102013001520
(43) Veröffentlichungstag der Anmeldung: 02.12.2015
(73) Patentinhaber: Fluorchemie GmbH Frankfurt, 65296 Frankfurt (DE)
(72) Erfinder: ROCKTÄSCHEL, Christian, 50126 Bergheim (DE)
(74) Vertreter: Schäfer, Matthias W.
(86) Internationale Anmeldenummer: PCT/DE2014/000013
(87) Internationale Veröffentlichungsnummer: WO 2014/114283

(56) Entgegenhaltungen:
- WO-A1-2012/126487
- CN-A- 101 624 457
- SUNIL K. SHARMA ET AL: FIRE TECHNOLOGY, Bd. 38, Nr. 1, 1. Januar 2002 (2002-01-01) , Seiten 57-70, XP055012990, ISSN: 0015-2684, DOI: 10.1023/A:1013428831840

## Beschreibung

### Gebiet der Erfindung

Die vorliegende Erfindung betrifft ein modifizierten, karbonisierten Rotschlamm (MKRS-HT), der im Hochtemperaturbereich als Flammhemmer eingesetzt werden kann, sowie modifizierten, karbonisierten und rehydratisierten Rotschlamm, der sowohl im Niedrigtemperaturbereich als auch im Hochtemperaturbereich als Flammhemmer eingesetzt werden kann, und deren Verwendungen.

### Hintergrund der Erfindung

Es ist bekannt, dass Rotschlamm beim Bayer-Verfahren zur Gewinnung von Aluminiumhydroxid (ATH) aus Bauxit als Abfallprodukt anfällt Unter Rotschlamm (RS) wird im folgenden der beim Bayer-Verfahren entstandene Rückstand verstanden, der bei der Gewinnung von ATH aus Bauxit anfällt.

Rotschlamm (RS), der in gewisser Weise als Bauxit minus ATH dargestellt werden kann, ist eine äußerst heterogene Substanz hinsichtlich seiner chemischen und mineralogischen Zusammensetzung, seiner endothermen Eigenschaften, seines pH- Wertes, etc. Die Ursache für die Heterogenität liegt einmal in der unterschiedlichen Zusammensetzung der eingesetzten Bauxite, vor allem aber darin, ob das Bayer-Verfahren mit Autoklavenaufschluss oder mit Rohraufschluss arbeitet. Beim Autoklavenverfahren wird der Aufschluss mit 30 bis 35 prozentiger Natronlauge bei Temperaturen von 170 - 180 °C durchgeführt, so dass sich ein Druck von 6 bis 8 bar einstellt. Das Rohraufschlussverfahren wurde entwickelt, um die Reaktionszeit von 6 bis 8 Stunden durch Temperaturerhöhung auf 270 °C auf weniger als 1 Stunde zu verkürzen. Bei dieser Temperatur stellt sich allerdings ein Wasserdampfdruck von 60 bar am Ende des Reaktors ein. Die höheren Temperaturen des Rohraufschlusses beeinflussen auch die Zusammensetzung des Rotschlamms. Beispielsweise wird im System Eisenhydroxid/Oxidhydrat im Rohraufschlussverfahren das Gleichgewicht fast vollständig zu Hämatit (Fe₂O₃) hin verschoben. Aufgrund der Heterogenität des Rotschlamms (RS) sind seine wirtschaftlichen Verwendungsmöglichkeiten eingeschränkt, so dass er überwiegend als Abfall auf Deponien entsorgt werden muss.

In der WO 2012/126487 A1 wurde ein so genanntes "Zero-Halogen Flame Retardent" (OHFR)-System, basierend auf modifiziertem rehydratisiertem Rotschlamm (MR2S) beschrieben, das sich als ein kostengünstiges OHFR-System für technische Anwendungen im Wire & Cable-Bereich oder für bautechnische und kunststofftechnische Anwendungen eignet. Mit Hilfe des in der WO 2012/126487 A1 offenbarten modifizierten rehydratisierten Rotschlamms kann eine flammhemmende Wirkung im Temperaturbereich von ca. 200°C - 350°C erreicht werden. Die flammhemmende Wirkung kommt dadurch zustande, dass sich die bei der Rehydratisierung des Rotschlamms entstandenen Hydroxide und Oxidhydrate des Aluminiums und Eisens - wie z. B. Gibbsit und Boehmit oder Goethit - in Oxide und Wasser zersetzen. Anwendung finden solche Produkte z. B. in Polymersystemen wie PVC oder EVA (PE). Bisher im Markt eingesetzte Produkte wie ATH oder APP reagieren zwischen 180° und 220° C und gelten als Niedrigtemperatur-Produkte. Zwischen 220° und 340° C werden Produkte wie MDH und Brucit eingesetzt, die als Hochtemperatur-Produkte gelten. Die aus RS durch Rehydratisierung hergestellten Flammhemmer (MR2S) reagieren zwischen ca. 220° C und 350° C und decken damit nach gegenwärtig üblicher Definition sowohl den Niedrigtemperatur- wie den Hochtemperaturbereich ab.

Die CN 101 624 457 A offenbart ein PE-Polymer, das als Flammschutzmittel eine Kombination aus Rotschlamm und Synergisten enthält. Hierbei kommt ein herkömmlicher Rotschlamm, wie er z.B. nach einem Bayer-Verfahren erhalten wird, zum Einsatz, der SiO2, CaO, Al2O3 und Fe2O3 als Hauptbestandteile enthält, zerkleinert wird und bei 80-100°C getrocknet wird.

Sunil K. Sharma und A.A. Ansari beschreiben in Fire Technology, 38, 57-70, 2002,

Plastikmaterialien, die herkömmlichen Oxiden aus bestehenden Rotschlamm enthalten, und untersuchen das Verhalten dieser Plastikmaterialien gegenüber Feuer.

### Zusammenfassung der Erfindung

Der vorliegenden Erfindung liegt die Aufgabe zugrunde, Rotschlamm derart zu modifizieren, dass ein kommerziell verwertbarer kostengünstiger Grundstoff mit reproduzierbaren Eigenschaften und definierter chemischer Zusammensetzung zur Verfügung gestellt wird.

Durch Reduktion von Rotschlamm im saueren Milieu können aus den im Rotschlamm vorliegenden Fe(III)-Verbindungen Fe(II)-Salzlösungen erhalten werden, aus denen durch Zugabe von beispielsweise NaHCO₃, Na2CO₃ oder CaCO₃ Eisen(II)-carbonat (Siderit) ausgefällt werden kann. Ohne an eine Theorie gebunden sein zu wollen, gehen die Erfinder davon aus, dass durch eine Karbonisierung von Rotschlamm unter Bildung von Eisen(II)-carbonat ein Hochtemperatur(HT)-Flammschutzmittel erhalten werden kann, der seine endotherme Wirkung durch Spaltung in Oxid und CO₂ bis zu Temperaturen von mehr als 500°C entfaltet. Neben der endothermen Reaktion wirkt das freigesetzte CO₂ als Flammschutzmittel.

Die vorliegende Erfindung betrifft daher modifizierten, karbonisierten Rotschlamm (MKRS-HT) mit einer mineralischen Zusammensetzung von
- 10 bis 50 Gewichtsprozent Eisenverbindungen,
- 12 bis 35 Gewichtsprozent Aluminiumverbindungen,
- 5 bis 17 Gewichtsprozent Siliziumverbindungen,
- 2 bis 10 Gewichtsprozent Titandioxid,
- 0,5 bis 6 Gewichtsprozent Calciumverbindungen und
- gegebenenfalls unvermeidbare Verunreinigungen,
wobei das Gewichtsverhältnis von Fe(II)carbonat zu den Oxiden des Eisens mindestens 1 ist.

Da dieses Produkt durch Karbonisierung entsteht, erhält es den Namen MKRS (modifizierter karbonisierter Rotschlamm). Da es sich um einen Hochtemperatur-Flammhemmer handeln kann, erhält dieser den Zusatz HT (Hochtemperatur), seine Bezeichnung ist also MKRS-HT.

Der modifizierte karbonsierte Rotschlamm kann insbesondere ein modifizierter, karbonisierter und rehydratisierter Rotschlamm sein, bei dem das Gewichtsverhältnis von Fe(II)carbonat und das Gewichtsverhältnis der Summe von Eisenhydroxid und Eisenoxidhydrat zu den Oxiden des Eisens mindestens 1 beträgt.

In diesem Fall liegen vorzugsweise neben den Hydroxiden/Oxidhydraten des Eisens und Fe(II)-Carbonat auch Hydroxide/Oxidhydrate des Aluminiums vor, die beispielsweise eine weitere Verstärkung einer flammhemmenden Wirkung aufgrund ihrer endothermen Eigenschaften erzeugen können. Zusätzlich können noch Phasenumwandlungen in anderen Bestandteilen des Rotschlamm endotherm zur Wirkung kommen. Insgesamt können in mit solchen erfindungsgemäßen OHFR-Produkten ausgerüstete Polymercompounds endotherme Reaktionen über einen Temperaturbereich von 180°C bis mehr als 500°C ablaufen. Zusätzlich wird noch flammhemmendes CO2 freigesetzt.

Es wird ferner ein Verfahren zur Herstellung von modifiziertem, karbonisierten Rotschlamm (MKRS-HT) beschrieben, umfassend die Schritte:
a) Bereitstellen von Rotschlamm,
b) Reduzieren der in dem Rotschlamm enthaltenen Eisen(III)-Verbindungen in saurer Lösung zu Eisen(II)-Verbindungen,
c) Zugeben einer Carbonatverbindung zu der in Schritt b) erhaltenen Eisen(II)-Verbindungen enthaltenden Lösung, wobei Eisen(II)carbonat (Siderit) gebildet wird.

Weiterhin wurde herausgefunden, dass chemisch modifizierter, rehydratisierter und karbonisierter Rotschlamm sowie Mischungen daraus eine Dichte von ca. 3,8 - 3,9 10³ kg / m³ aufweisen und damit BaSO4 (Schwerspat), der eine Dichte von 4,43 10³ kg / m³ hat, nahe kommen. BaSO4 wird wegen seines spezifischen Gewichts unter anderem auch als schwerer Füllstoff in Kunststoffen eingesetzt. Erfindungsgemäß kann nun an Stelle von Schwerspat chemisch modifizierter Rotschlamm MR2S-NT bzw. MKRS-HT oder Mischungen davon eingesetzt werden.

Weiterhin zeigen chemisch modifizierter, rehydratisierter und karbonisierter Rotschlamm sowie Mischungen daraus in Verbindung mit einer Trägermatrix eine schalldämmende Wirkung. Sind also Kunststoffe oder z. B. Baustoffe mit diesen Produkten ausgerüstet, tritt neben der flammhemmenden auch eine schalldämmende Wirkung auf. Diese Doppelwirkung ist insbesondere bei Einsatz im Fahrzeugbau und Baubereich interessant. Baustoffe können auch mineralische Produkte wie Estrich, Beton, Gipskartonplatten, etc. sein, die dann eine entsprechende Schalldämmung aufweisen.

### Ausführliche Beschreibung der Erfindung

Die Begriffe "Flammschutzmittel", "flammhemmendes Mittel", "Flammhemmer" und "OHFR-Agenzien" oder auch die Abkürzung "FR" (englisch: flame retardant) sind in der vorliegenden Beschreibung als Synonyme zu verstehen. Hierunter werden im Sinne der vorliegenden Erfindung insbesondere nicht toxische, halogenfreie, anorganische Flammschutzmittel verstanden.

Unter "Niedrigtemperaturbereich" wird in der vorliegenden Beschreibung der Temperaturbereich zwischen 220° C und 350° C verstanden.

Unter "Hochtemperaturbereich" wird in der vorliegenden Beschreibung der Temperaturbereich zwischen 350° C und 500° C verstanden.

Unter dem Begriff "brandgeschütztes Stoffsystem" wird ein Gegenstand verstanden, bei dem ein brennbares Material mit einem flammhemmenden Mittel in Verbindung gebracht wird, so dass das Entzünden des in dem Gegenstand vorhandenen brennbaren Materials durch Feuer oder Hitze verhindert oder verlangsamt wird. Insbesondere ist das flammhemmende Mittel mit dem brennbaren Material fest verbunden, beispielsweise durch Vermengen oder Beschichten.

Unter "brennbaren Materialien" oder "entflammbaren Materialien" werden jegliche Materialien verstanden, die brennbar oder entflammbar sind, insbesondere Polymere und nicht flüchtige Kohlenwasserstoffe. Beispiele sind Acryldispersionen, Acrylharze, Elastomere, Epoxidharze, Latexdispersionen, Melaminharze, Polyamid (PA), Polyethylen (PE), PE-Copolymere, thermoplastische PE-Copolymere, vernetzte PE-Copolymere, Phenolharze, Polyesterharze (UP), Polyurethan, Polypropylen (PP), Polyvinylchlorid (PVC), PVC-Plastisole, thermoplastische Elastomere wie z. B. TPE, TPA, TPU, etc., Vinylesterharze und Bitumen. Brennbar und entflammbar sind hier als Synonyme zu verstehen.

Unter Rotschlamm (RS) wird der beim Bayer-Verfahren entstehende Rückstand verstanden, der bei der Gewinnung von ATH aus Bauxit anfällt. Weitere Informationen zu Rotschlamm finden sich in der WO 2012/126487 A1, deren Offenbarung hiermit vollumfänglich als integraler Bestandteil dieser Anmeldung aufgenommen wird. Unter modifiziertem, karbonisierten Rotschlamm (MKRS-HT) wird ein Produkt verstanden, das aus Rotschlamm (RS) durch Karbonisierung und ggf. Trocknen, Mahlen, Zumischen anderer Substanzen, Beschichtung der Oberfläche, etc. hergestellt wird. Unter modifiziertem, karbonisierten und rehydratisiertem Rotschlamm wird ein Produkt verstanden, das aus Rotschlamm (RS) durch Karbonisierung sowie Rehydratisierung und ggf. Trocknen, Mahlen, Zumischen anderer Substanzen, Beschichtung der Oberfläche, etc. hergestellt wird.

Die vorliegende Erfindung betrifft einen modifizierten, karbonisierten Rotschlamm (MKRS-HT) mit einer mineralischen Zusammensetzung von
- 10 bis 50 Gewichtsprozent Eisenverbindungen,
- 12 bis 35 Gewichtsprozent Aluminiumverbindungen,
- 5 bis 17 Gewichtsprozent Siliziumverbindungen,
- 2 bis 10 Gewichtsprozent Titandioxid,
- 0,5 bis 6 Gewichtsprozent Calciumverbindungen und
- gegebenenfalls unvermeidbare Verunreinigungen,
wobei das Gewichtsverhältnis von Fe(II)carbonat zu den Oxiden des Eisens mindestens 1 ist.

In dem modifizierte, karbonisierten Rotschlamm (MKRS-HT) beträgt das Gewichtsverhältnis von Fe(II)carbonat zu den Oxiden des Eisens vorzugsweise mindestens 1, stärker bevorzugt mindestens 2, stärker bevorzugt mindestens 3, stärker bevorzugt mindestens 4, stärker bevorzugt mindestens 5, stärker bevorzugt mindestens 7, stärker bevorzugt mindestens 9, stärker bevorzugt mindestens 19. Zur Verdeutlichung, wenn beispielsweise das Gewichtsverhältnis von Fe(II)carbonat zu den Oxiden des Eisens 19 beträgt und unter der Annahme, dass sämtliche Eisenverbindungen entweder als Fe(II)carbonat oder als Oxide des Eisens vorliegen, liegen 95 Gewichtsprozent der Eisenverbindungen als Fe(II)carbonat und 5 Gewichtsprozent der Eisenverbindungen als Oxide des Eisens vor.

Der modifizierte karbonsierte Rotschlamm kann insbesondere ein modifizierter, karbonisierter und rehydratisierter Rotschlamm (MKRS-HT/MR2S-NT) sein, bei dem das Gewichtsverhältnis von Fe(II)carbonat und das Gewichtsverhältnis der Summe von Eisenhydroxid und Eisenoxidhydrat zu den Oxiden des Eisens mindestens 1 beträgt.

In dem modifizierten, karbonisierten und rehydratisierten Rotschlamm beträgt das Gewichtsverhältnis von Fe(II)carbonat und Eisenhydroxid/Oxidhydraten zu den Oxiden des Eisens vorzugsweise mindestens 1, stärker bevorzugt mindestens 1,5, stärker bevorzugt mindestens 2, stärker bevorzugt mindestens 3, stärker bevorzugt mindestens 4, stärker bevorzugt mindestens 5, stärker bevorzugt mindestens 7, stärker bevorzugt mindestens 9, stärker bevorzugt mindestens 19.

Zur Verdeutlichung, wenn beispielsweise das Gewichtsverhältnis von Fe(II)carbonat zu den Oxiden des Eisens 2 beträgt und das Gewichtsverhältnis der Summe von Eisenhydroxid und Eisenoxidhydrat zu den Oxiden des Eisens ebenfalls 2 beträgt und unter der Annahme, dass sämtliche Eisenverbindungen entweder als Fe(II)carbonat, Eisenhydroxid, Eisenoxidhydrat oder als Oxide des Eisens vorliegen, liegen 40 Gewichtsprozent der Eisenverbindungen als Fe(II)carbonat, 40 Gewichtsprozent der Eisenverbindungen als Eisenhydroxid bzw. Eisenoxidhydrat und 20 Gewichtsprozent der Eisenverbindungen als Oxide des Eisens vor.

In dem modifizierten, karbonisierten und rehydratisierten Rotschlamm liegen vorzugsweise neben den Hydroxiden/Oxidhydraten des Eisens und Fe(II)-Carbonat, auch

Hydroxide/Oxidhydrate des Aluminiums vor, die eine weitere Verstärkung der flammhemmenden Wirkung aufgrund ihrer endothermen Eigenschaften erzeugen können. Hierbei beträgt das Gewichtsverhältnis der Summe von Aluminiumhydroxid und Aluminiumoxidhydrat zu Aluminiumoxid vorzugsweise mindestens 1, stärker bevorzugt mindestens 1,5, stärker bevorzugt mindestens 2, stärker bevorzugt mindestens 3, stärker bevorzugt mindestens 4, stärker bevorzugt mindestens 5, stärker bevorzugt mindestens 7, stärker bevorzugt mindestens 9, stärker bevorzugt mindestens 19.

Sofern nicht explizit etwas anderes vermerkt ist, gelten die folgenden Ausführungen sowohl für den erfindungsgemäßen modifizierten, karbonisierten Rotschlamm (MKRS-HT) als auch für den erfindungsgemäßen modifizierten, karbonisierten und rehydratisierten Rotschlamm (MKRS-HT/MR2S-NT), die beide zusammengenommen im folgenden auch vereinfacht als "modifizierter Rotschlamm" oder bezeichnet werden.

Die mineralische Zusammensetzung des modifizierten Rotschlamms umfasst:
- 10 bis 50 Gewichtsprozent Eisenverbindungen,
- 12 bis 35 Gewichtsprozent Aluminiumverbindungen,
- 5 bis 17 Gewichtsprozent Siliziumverbindungen,
- 2 bis 10 Gewichtsprozent Titandioxid,
- 0,5 bis 6 Gewichtsprozent Calciumverbindungen und
- gegebenenfalls unvermeidbare Verunreinigungen.

Dabei kann die mineralische Zusammensetzung des modifizierten Rotschlamms 10 bis 45, 30 bis 50, oder 20 bis 40 Gewichtsprozent Eisenverbindungen umfassen.

Dabei kann die mineralische Zusammensetzung 12 bis 30, 20 bis 35, oder 15 bis 25 Gewichtsprozent Aluminiumverbindungen umfassen.

Dabei kann die mineralische Zusammensetzung 5 bis 15, 8 bis 17, oder 7 bis 16 Gewichtsprozent Siliziumverbindungen, insbesondere SiO₂, umfassen.

Dabei kann die mineralische Zusammensetzung 4 bis 10, 2 bis 8, oder 3 bis 9 Gewichtsprozent Titandioxid (TiO₂) umfassen.

Dabei kann die mineralische Zusammensetzung 1 bis 6, 0,5 bis 2,5, 0,75 bis 4, oder 0,6 bis 1,5 Gewichtsprozent Calciumverbindungen, insbesondere CaO, umfassen.

Dabei kann jeder der oben angegebenen Bereiche kombiniert werden.

Unter "unvermeidbare Verunreinigungen" werden Bestandteile verstanden, die als Verunreinigung in den Ausgangsmaterialen, beispielsweise in dem einem Bayer-Verfahren unterworfenen Bauxit, oder Verunreinigungen, die herstellungsbedingt entstehen oder Eingang in das Produkt finden. Insbesondere aufgrund der Heterogenität des Rotschlamms, wie eingangs erwähnt, sind solche Verunreinigungen nicht vermeidbar. Sie tragen aber nicht entscheidend zur flammhemmenden Wirkung des modifizierten Rotschlamms bei.

In einer Weiterbildung der Erfindung beträgt der Anteil an wasserlöslichem Natriumverbindungen, ausgedrückt als Gewichtsprozent Na₂O, in dem modifizierten Rotschlamm nicht mehr als 0,03, vorzugsweise 0,003 bis 0,03 Gewichtsprozent.

In noch einer Weiterbildung der Erfindung beträgt die mittlere Teilchengröße (d50) in dem modifizierten Rotschlamm nicht mehr als 50 µm, vorzugsweise 0,5 bis 10 µm oder 1 bis 5 µm (mikroskaliger modifizierte Rotschlamm) bzw. 100 bis 900 nm oder 200 bis 750 nm (nanoskaliger modifizierte Rotschlamm).

In noch einer Weiterbildung der Erfindung beträgt die Restfeuchte des modifizierten Rotschlamms nicht mehr als 0,4 Gewichtsprozent, vorzugsweise nicht mehr als 0,3 Gewichtsprozent, vorzugsweise nicht mehr als 0,2 Gewichtsprozent.

Die chemische Zusammensetzung von Rotschlamm ist in Tabelle 1, die chemische Zusammensetzung von MKRS-HT in Tabelle 2 und die chemische Zusammensetzung von modifiziertem, karbonisierten und rehydratisierten Rotschlamm in Tabelle 3 (MKRS-HT/MR2S-NT) dargestellt

**Tabelle 1**

| **Rotschlamm (Gewichtsprozent)** | | |
|---|---|---|
| | Typisch | Bandbreite |
| Eisenverbindungen | 40 | 10 - 50 |
| Aluminiumverbindungen | 25 | 12 - 35 |
| Siliziumverbindungen (v.a. SiO₂) | 15 | 5 - 17 |
| Titandioxid | 7 | 2 - 10 |
| Calciumverbindungen | 1 | 0,5 - 6 |
| Natriumverbindungen | 9 | 3 - 10 |
| Sonstige | 3 | 0 - 3 |

**Tabelle 2**

| **MKRS** - **HT** | |
|---|---|
| Eisenverbindungen | Gewichtsverhältnis von Fe(II)carbonat zu den Oxiden des Eisens mindestens 1 |
| Aluminiumverbindungen | unverändert als Al-Salze oder Al₂O₃ |
| Na₂O lösl. | vorzugsweise kleiner gleich 0,03 Gewichts% |
| andere Bestandteile des RS | unverändert |
| mittlere Teilchengröße (d 50) | vorzugsweise kleiner gleich 50 µm, vorzugsweise 0,5 - 10 µm |
| Restfeuchte | vorzugsweise kleiner gleich 0,4 Gewichts% |

**Tabelle 3**

| **MKRS-HT/MR2S-NT** | |
|---|---|
| Eisenverbindungen | Gewichtsverhältnis von Fe(II)carbonat und der Summe von Eisenhydroxid und Eisenoxidhydrat zu den Oxiden des Eisens mindestens 1 |
| Aluminiumverbindungen | Gewichtsverhältnis der Summe von Aluminiumhydroxid und - oxidhydrat zu Aluminiumoxid vorzugsweise mindestens 1 |
| Na₂O lösl. | vorzugsweise kleiner gleich 0,03 Gewichts% |
| andere Bestandteile des RS | unverändert |
| mittlere Teilchengröße (d 50) | vorzugsweise kleiner gleich 50 µm, vorzugsweise 0,5 - 10 µm |
| Restfeuchte | vorzugsweise kleiner gleich 0,4 Gewichts% |

Es ist weiterhin bevorzugt, wenn die Oberfläche des modifizierten Rotschlamms mit mindestens einer Substanz versehen ist, welche die Verträglichkeit der Teilchen des modifizierten Rotschlamms mit einer Polymermatrix verbessert. Hierdurch kann die Einarbeitung des modifizierten Rotschlamms in das zu schützende brennbare Material, das in der Regel eine Polymermatrix aufweist, erleichtert werden und die Bindung der Komponenten verbessert werden. Ebenfalls kann hierdurch das Eigenschaftprofil des Polymercompounds gezielt gesteuert werden.

Als vorteilhaft hat sich hierbei erwiesen, wenn die Substanz ein Oberflächenmodifizierungsmittel ist, ausgewählt aus der Gruppe, bestehend aus Organosilanen, Organotitanaten, Organo-Zirkonaluminaten, Carbonsäurederivaten, Weichmachern, Oligomer- und Polymer-Vorstufen, Ionomeren, Borsäure und deren Metallsalze und Derivate, Zinkstannaten, Zinkhydroxystannaten oder Kombinationen hiervon.

In einer weiteren bevorzugten Ausführungsform liegt der modifizierte Rotschlamm in Kombination mit Synergisten, insbesondere Organoclays (Nanoclays), Zinnverbindungen und Boraten, vor.

Es ist ebenfalls bevorzugt, wenn der modifizierte Rotschlamm ferner mindestens einen weiteren flammhemmenden Zusatz in einem Anteil bis zu 70 Gewichtsprozent, vorzugsweise 5 bis 60 Gewichtsprozent, stärker bevorzugt 10 bis 50 Gewichtsprozent, stärker bevorzugt 15 bis 40 Gewichtsprozent enthält.

Als weiterer flammhemmender Zusatz eignet sich insbesondere eine endotherm reagierende Substanz, vorzugsweise eine endotherm reagierende Substanz, ausgewählt aus der Gruppe, bestehend aus Aluminiumhydroxid, Boehmit, Gibbsit, Goethit, Magnesiumhydroxid, Huntit, Brucit oder Mischungen hiervon.

Ein Verfahren zur Herstellung des modifizierten, karbonisierten Rotschlamms (MKRS-HT) umfasst die Schritte:
a) Bereitstellen von Rotschlamm,
b) Reduzieren der in dem Rotschlamm enthaltenen Eisen(III)-Verbindungen in saurer Lösung zu Eisen(II)-Verbindungen,
c) Zugeben einer Carbonatverbindung zu der in Schritt b) erhaltenen Eisen(II)-Verbindungen enthaltenden Lösung, wobei Eisen(II)carbonat (Siderit) gebildet wird.

Bevorzugte Reduktionsmittel, die in Schritt b) eingesetzt werden können, sind schwefelhaltige Reduktionsmittel, insbesondere Natriumdithionit (Na₂S₂O₄) und Schwefeldioxid (SO₂).

Die Reduktion der in dem Rotschlamm enthaltenen Eisen(III)-Verbindungen zu Eisen(II)-Verbindungen gemäß Schritt b) findet vorzugsweise in schwach saurer Lösung, beispielsweise bei einem pH-Wert von 4 bis 6, insbesondere einem pH-Wert von 4,5 bis 5,5, statt.

Bevorzugte Carbonatverbindungen, die in Schritt c) eingesetzt werden können, sind Alkalicarbonate, Alkalihydrogencarbonate und Erdalkalicarbonate, insbesondere Natriumcarbonat (Na₂CO₃), Natriumhydrogencarbonat (NaHCO₃) und Calciumcarbonat (CaCO₃). Gegebenenfalls muss, wie es dem Fachmann aufgrund seines Fachwissens ersichtlich ist, der pH-Wert der in Schritt b) erhaltenen sauren Eisen(II)-Verbindungen enthaltenden Lösung vor dem Schritt c) in geeigneter Weise eingestellt werden, um durch Zugabe einer Carbonatverbindung Eisen(II)-carbonat (Siderit) zu erhalten.

Ein weiteres Verfahren zur Herstellung des modifizierten Rotschlamms umfasst die Schritte:
a) Bereitstellen von Rotschlamm (RS);
b) Separate Herstellung von Eisen(II)carbonat aus zur Verfügung stehenden Ausgangssubstanzen;
c) Vermischen von RS und Eisen(II)carbonat
d) Erhalten von modifiziertem carbonisiertem Rotschlamm (MKRS-hat).

Auf diesem Weg kann das Eisen(II)carbonat leicht Modifikationen durch physikalische und/oder chemische Methoden unterzogen werden, um speziell anwendungstechnische Eigenschaften zu erreichen.

Der erfindungsgemäße modifizierte, karbonisierte und rehydratisierte Rotschlamm kann hergestellt werden, indem modifizierter, karbonisierter Rotschlamm (MKRS-HT), wie beispeilsweise oben beschrieben, und modifizerter, rehydratisierter Rotschlamm (MR2S-NT), wie beispielsweise in der WO 2012/126487 A1, deren Offenbarung hiermit vollumfänglich aufgenommen wird, beschrieben, getrennt voneinander hergestellt werden und anschließend unter Erhalt des modifizierten, karbonisierten und rehydratisierten Rotschlamms vermischt werden.

Durch geeignete Reaktionsführung ist es aber auch möglich, im Rotschlamm sowohl eine Rehydratisierung als auch eine Karbonsierung unter Erhalt des modifizierten, karbonisierten und rehydratisierten Rotschlamms ablaufen zu lassen. Um die Modifizierung gezielt in die eine oder andere Richtung zu lenken, können geeignete technische Maßnahmen ergriffen werden, wie z.B. Reaktionsführung unter (oxidativ) inertem Prozeßgas, spezielle Trocknung mit unmittelbar anschließender Oberflächenmodifizierung ("Versiegelung") für eine bevorzugte Modifizierung in Richtung Siderit. Soll hingegen überwiegend Goethit entstehen, wird mit Luftsauerstoff oder alternativ Ozon gearbeitet, die die Fe(II)-Salzlösungen zu Fe(III)-Salzlösungen oxidieren. Mit Anheben des pH-Werts fällt Goethit an, der ebenfalls getrocknet und oberflächenversiegelt werden kann.

Die Oberflächenmodifizierung/Versiegelung dient darüber hinaus dazu eine optimale Anbindung der Polymermoleküle in der Interphase zum OHFR-Flammhemmer zu garantieren. Hierdurch werden die Compoundeigenschaften gezielt gesteuert.

Durch eine gezielte Prozeßführung unter Inertgas oder mit Luftsauerstoff, Trocknung und Oberflächenmodifizierung ist die Herstellung eines für die gewünschte Verwendung maßgeschneiderten, karbonisierten und rehydratisierten Rotschlamms möglich.

Das so genannte inerte Prozessgas/ Schutzgas sollte von allen oxidierend wirkenden Komponenten, speziell (Luft-)Sauerstoff frei sein. Eingesetzt wird insbesondere ein zu gleichen Teilen aus Stickstoff und Argon (WIG- Schweiß- Qualität ist ausreichend) zusammengesetztes Prozessgas, welches im Kreislauf gefahren wird.

Im folgenden werden Beispiele, Versuche und weitere Ausführungsformen beschrieben, die allerdings nicht zur Beschränkung der vorliegenden Erfindung führen sollen. Vielmehr dienen sie der Verdeutlichung der erfindungsgemäßen Lehre und deren Vorteile.

### Herstellung von modifiziertem Rotschlamm:

### Beispiele

### Beispiel 1

4 g Rotschlamm mit einem Fe2O3-Gehalt von 40 % (1,6 g Fe2O3 = 0,01 mol) wurden im Becherglas mit 60 ml konzentrierter Salzsäure (0,6 mol) versetzt und 24h bei Raumtemperatur gerührt.

Nach diesem Zeitraum konnte ein Rückstand von 3,2 g abgetrennt werden, d. h. 0,8 g Fe2O3 hatten sich aufgelöst (50 %). Bei längerem Rühren und höheren Temperaturen kann weiteres Fe2O3 aufgelöst werden.

Der ph-Wert der Filtratlösung wurde mit verdünnter NaOH (0,5 mol NaOH in 100 ml Wasser) auf 4,5 eingestellt. Danach wurden 0,05 mol Na2SO3 x 7 H2O (1,3 g) in 50 ml H2O zugegeben. Nach einigen Stunden wurde die gelbe Lösung nahezu farblos. Aus dieser Lösung wurden durch Zugabe von 0,8 g Na2CO3 1,2 g Fällungsprodukt erzeugt. Dieses Produkt bestand gemäß PXRD zu jeweils 50 % aus Siderit und Goethit. Nach längerem Zeitraum färbt sich das ausgefällte Produkt zunächst grünlich und dann braun, d. h. das Fe(II)carbonat hat sich an der Luft zu Fe(III)-Verbindungen oxidiert. Wird dagegen Sauerstoff ausgeschlossen, fällt überwiegend Siderit an, der langfristig stabil bleibt.

Es zeigt sich also, dass unter inerten Bedingungen Siderit ausgefällt wird, unter oxidativen Bedingungen am Ende Goethit. Zwischenstufen, die Siderit und Goethit enthalten, können jederzeit abgefangen und getrocknet und ggf. oberflächenversiegelt werden.

### Beispiel 2

Die eingesetzten Geräte sind vorzugsweise ein entsprechend ausgerüsteter Sprühturm (von NIRO Atomizer, Copenhagen). Hierbei fällt das getrocknete und optional gleichzeitig oberflächenmodifizierte Material z. B. gemäß Oberflächenmodifizierung "A" (s.unten) mikroskalig an. Falls aus anwendungstechnischen Gründen ein nanoskaliges Material benötigt wird, kann die Oberflächenbeschichtung nach dem Trocknen mittels eines Swirl Fluidizers in dem nach geschalteten Fluidmischer/Schnellmischer durchgeführt werden.

### Sprühturm:

Im Sprühturm erfolgt vorzugsweise die Trocknung, die Einstellung der Kornverteilungskurve (Top-cut; d90, d50 und d10) und optional die Oberflächenmodifizierung des Materials.

Im hier dargestellten Fall, d.h. mit Oberflächenmodifizierung "A", wird dem einzutragenden Slurry mit einem Feststoffgehalt, welcher in weiten Grenzen variiert werden kann, von zum Beispiel 50 %, die entsprechende Menge an Amino-propyl-tris ethoxy-silan (1 Gew.% AMEO von Evonik/Degussa bezogen auf den Feststoffgehalt ; siehe Kapitel "Oberflächenmodifizierung") unter intensivem Rühren zugesetzt. Das Organosilan reagiert durch Hydrolyse zu einem Oligo-organosilanol, welches auf die Oberfläche des zu trocknenden Materials aufzieht und dort unter Bildung kovalenter Bindungen fixiert wird (siehe Edwin S. Plueddeman, Silane Technology, Elsevier, NY, USA)

Zusätzlich ist dem Slurry 0.3 Gew.% (bezogen auf den Feststoffgehalt) DISPEX A 80 als Dispergier- und Verflüssigungsmittel, welches die Pumpbarkeit des Slurries erst ermöglicht, zugefügt.

Die Sekundärpartikelgröße (d.h. der gewünschte Agglomerationsgrad) wird durch die Variation von der Eintritts- (typischerweise zwischen 500 °C und 300 °C) und Austrittstemperatur (typischerweise zwischen 120 °C und 60 °C) des Prozessgases, der Sprühscheiben-Umdrehungszahl, der Zahl und Geometrie der Düsenöffnungen, des Durchsatzes pro Stunde an Slurry, in Grenzen auch über die Slurry-Konzentration (Feststoffgehalt) eingestellt.

Wird der Sprühturm, ohne die Aminosilan-Oberflächenmodifizierung verwendet, entsteht ein mikroskaliger MR2S-NT oder MKRS-HT mit optimiertem Goethit- oder Siderit-Gehalt (je nach Optimierungswunsch entsprechend der oben beschriebenen Prozessführung).

Optional wird in einer nach geschalteten Stiftmühle (Fa. Alpine) "des-agglomeriert", d.h die mittlere Teilchengröße auf eine Bandbreite von 1 bis 1,5 µm (d50) eingestellt.

Die Kornverteilungskurve entspricht in etwa der eines feinteilig gefällten Aluminumhydroxids, wie z.B. MARTINAL OL 104 (Martinswerk / Albemarle) oder SUPERFINE SF4ESD (Alcan Ltd.), oder der eines synthetischen Magnesiumhydroxids, wie z.B. MAGNIFIN H5 (Magnesit Prod. Gesellschaft).

Diese Kornverteilungskurve ermöglicht ein nahezu optimales Compoundieren in die meisten thermoplastischen und duroplastischen Polymersysteme sowie in Kautschuksysteme. Das gleiche trifft auf alle thermoplastischen Elastomer (TPE)-Systeme zu.

### Swirl Fluidizer:

Im Swirl Fluidizer erfolgt vorzugsweise die Trocknung und die Einstellung eines nanoskaligen Produktes.

Die optionale Oberflächenmodifizierung wird ausschließlich im nach geschalteten Fluidmischer (Schnellmischer) vorgenommen.

Hierbei kann eine Vielzahl von Oberflächenmodifizierungsmitteln fester, flüssiger oder pastöser Konsistenz verwendet werden. Es ist auch eine in-situ Polymerisation auf der Oberfläche der OHFR-Systeme, wie MR2S-NT oder MKRS-HT, möglich.

Im Swirl Fluidizer wird unter den gleichen Prozessgasbedingungen wie im Sprühturm das erfindungsgemäße Material mittels einer frequenzgesteuerten Monoschnecke in den Reaktionsraum transportiert. Das entsprechend konfigurierte Werkzeug zerteilt das zu trocknende Material im Prozessgas, wobei vorwiegend nanoskalige Primärpartikel entstehen.

Durch den Durchsatz pro Stunde, die Eintritts- und Austrittstemperatur des Prozessgases, und die als Steuergröße gewählte Restfeuchte des erfindungsgemäßen Materials sowie die Konfiguration und die Umdrehungsgeschwindigkeit des Werkzeugs wird der Prozess gezielt so gesteuert, dass das Produkt nanoskalig anfällt.

Wenn eine Oberflächenmodifizierung durchgeführt werden soll, wird das trockene Material (Restfeuchte üblicherweise 0,05 %) über eine Zellradschleuse direkt in den nach geschalteten Fluidmischer dosiert und dort gemäß der Beschreibung "Oberflächenmodifizierung A ,B, C und D" beschichtet.

Hierbei wird die Austrittstemperatur des optimierten MR2S-NT oder MKRS-HT (typischerweise 80 °C), welche sich im Fluidmischer auf ca. 50 °C Equilibrium abkühlt, dazu benutzt, den Oberflächenmodifizierungsprozess effektiver zu gestalten, da sich das Mischgut schneller auf die jeweilige Reaktionstemperatur aufheizt.

Der Kühlmischer kühlt das Produkt auf Raumtemperatur ab, so dass sofort ohne Zwischensilo-Lagerung abgesackt werden kann.

### DTA- und TG-Analysen:

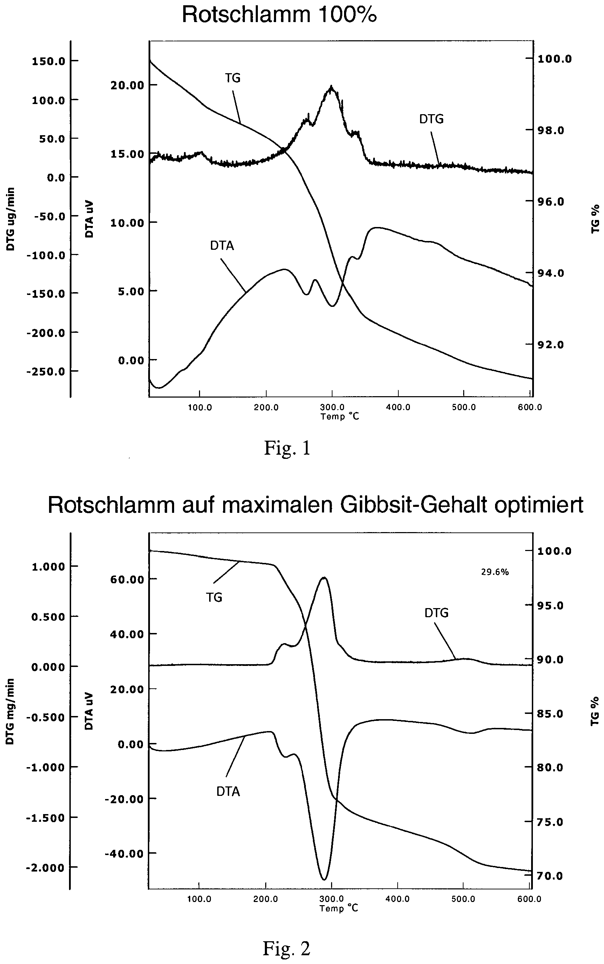

Figur 1 zeigt DTA- und TG-Kurven von Rotschlamm (Vergleichsbeispiel). Zwischen 220 °C und 350 °C sind endotherme Reaktionen sichtbar, die auf Restgehalte von Gibbsit/Boehmit und Goethit zurückzuführen sind. Im Rotschlamm sind die Zersetzungsintervalle von Hydroxiden/Oxidhydraten des Aluminiums und des Eisens in etwas höhere Temperaturbereiche verschoben.
Figur 2 zeigt DTA- und TG-Kurven von Rotschlamm, der in Richtung Gibbsit rehydratisiert worden ist (Referenzbeispiel). Dabei ist zusätzlich auch Goethit entstanden. Die endotherme Reaktion findet zwischen 210°C und 350°C statt.
Figur 3 zeigt DTA- und TG-Kurven von Rotschlamm, der in Richtung Goethit rehydratisiert worden ist (Referenzbeispiel). Dabei ist zusätzlich auch Gibbsit entstanden. Die endotherme Reaktion findet zwischen 210°C und 350°C statt.
Figur 4 zeigt DTA und TG-Kurven von Rotschlamm, der in Richtung Siderit karbonisiert worden ist (erfindungsgemäßes Beispiel: modifizierter, karbonisierter Rotschlamm (MKRS-HT)). Die endotherme Reaktion findet zwischen 350°C und 500°C statt, also im Hochtemperaturbereich (HT).
Figur 5 zeigt DTA- und TG-Kurven von Rotschlamm, der sowohl in Richtung Goethit rehydratisiert als auch in Richtung Siderit karbonisiert worden ist (erfindungsgemäßes Beispiel: modifizierter, karbonisierter und rehydratisierter Rotschlamm (MKRS-HT/MR2S-NT)). Die endotherme Reaktion findet für die Hydroxide/Oxidhydrate Goethit/Gibbsit zwischen 220°C und 350°C im Niedrigtemperaturbereich (NT) und für Siderit zwischen ca. 350°C - 500°C im Hochtemperaturbereich (HT) statt. Produkte dieser Art zeigen also endotherme Reaktionen von ca. 220°C bis 500°C.

### Röntgenographische Analysen:

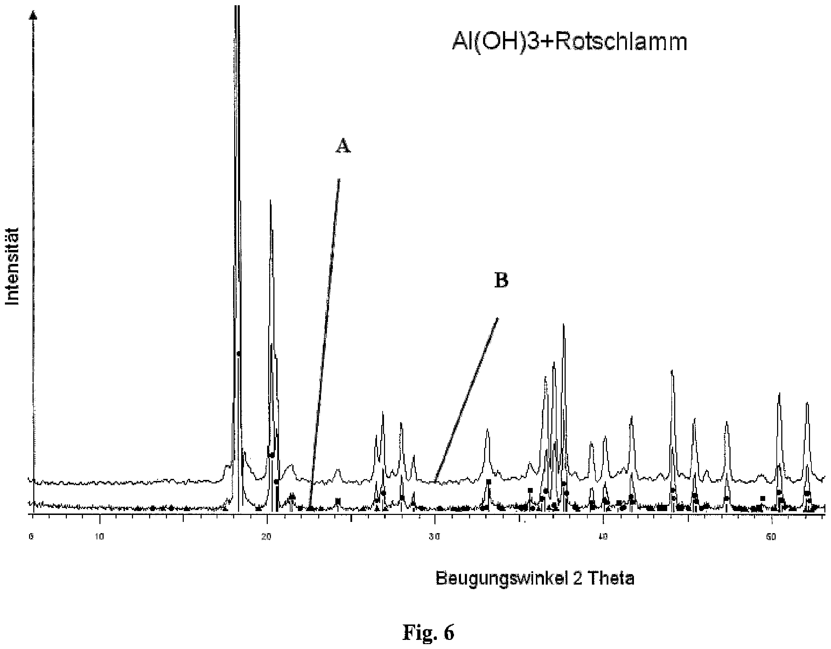

Figur 6 (Diagramm 1) zeigt das Röntgendiagramm von Rotschlamm, der in Richtung Gibbsit rehydratisiert worden ist (vgl. DTA- und TG-Kurven Figur 2). Die Liniendiagramme zeigen:
Liniendiagramm A:
   Typ: 2Th/Th locked - Start: 5.000 ° - End: 70.000 ° - Step: 0.040 °- Step time: °C (Room) - Time Started: 15 s - 2-Theta: 5.000 °- Theta: 2.500 °- Chi: 0.00 ° mm Operations: Import
Liniendiagramm B:
   Typ: 2Th/Th locked - Start: 5.000 °- End: 70.000 °- Step: 0.040 °- S (Room) - Time Started: 15 s - 2-Theta: 5.000 °- Theta: 2.500 °- Chi Operations: Y Scale Add 125 I Background 0.000,1.000 I Y Scale M Import

### Legende:

■ 00 033 0664 (*) - Hematit, syn - Fe203 - Y: 1.36 % - d x by: 1. - WL: 1.5406 - Rhombo.H.axes - a 5.03560 - b 5.03560 - c 13 120.000 - Primitiv - R-3c (167) - 6 - 301.926 - I/Ic PDF
● 01-070-2038 (C) - Gibbsit - Al(OH)3 - Y: 7.80% - d x by: 1. - WL: 1.5406 - Monoclinic - a 8.68400 - b 5.07800 - c 9.73600 - a
   Primitive - P21/n (14) - 8 - 427.985 - I/Ic PDF 1.8 - F30=6
▲ 00-049-0007 (*) - Natriumaluminiumsilikat - Na1.15Al1.15Si0.8504 - Y: 0.65 % - d x by: 1. - WL: 1.5406 - Orthorhombic - a 90.000 - beta 90.000 - gamma 90.000 - Primitiv - Pc21b

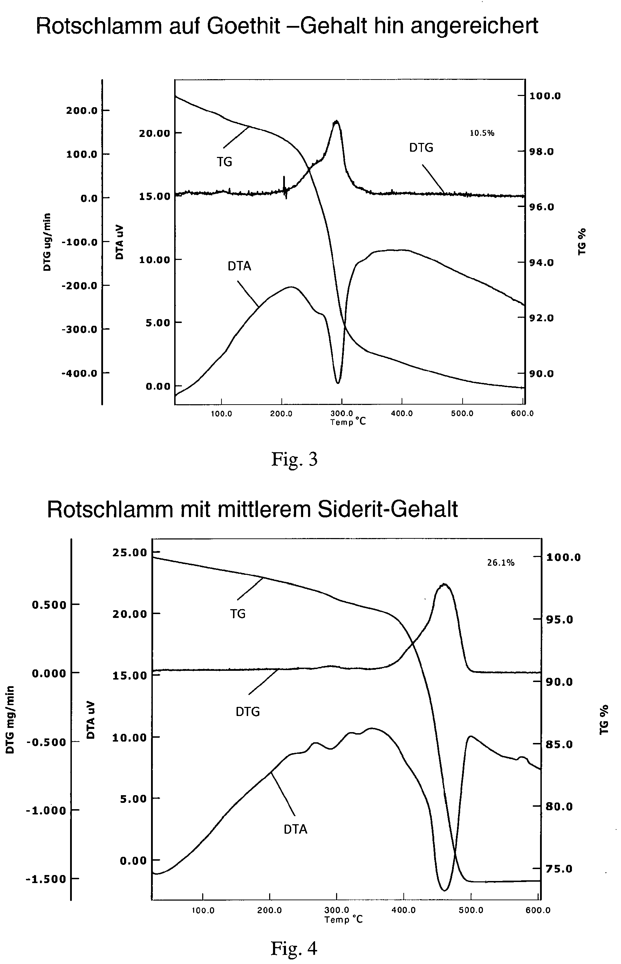

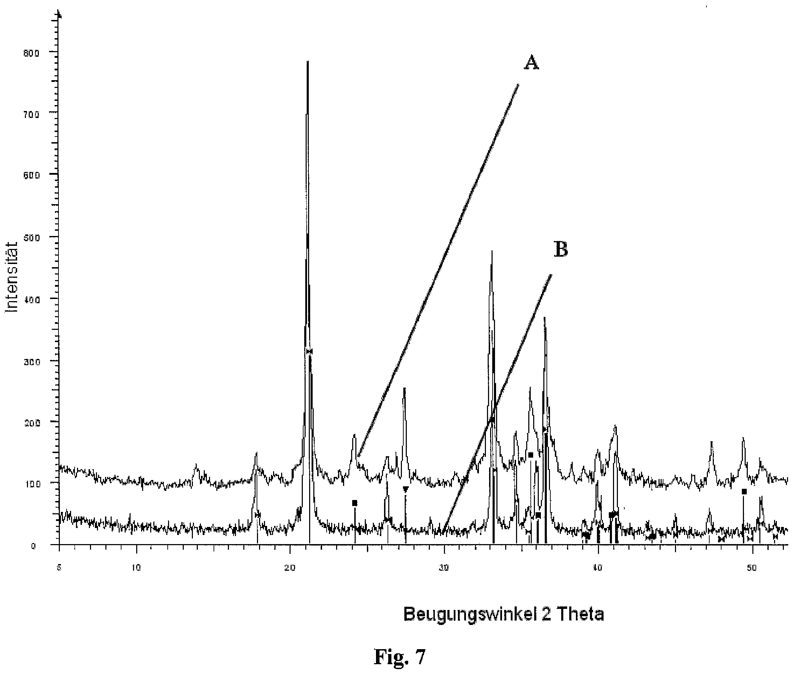

Figur 7 (Diagramm 2) zeigt das Röntgendiagramm von Rotschlamm, der in Richtung Goethit rehydratisiert worden ist (vgl. DTA- und TG-Kurven Figur 3). Die Liniendiagramme zeigen:
Liniendiagramm A:
   Typ: PSD fast scan - Start: 5.000 °- End
   time: 1. s - Temp.: 25 °C (Room) - Time
   Theta: 1.544 °- Phi: 0.00 °- Aux1: 0 0A
   Add 83 ∼ Range Op. A+B Import
Liniendiagramm B:
   Typ: 2Th/Th locked - Start: 5.000 °- End
   time: 10. s - Temp.: 25 °C (Room) - Time
   Theta: 2.500 °- Chi: 0.00 °- Phi: 0.00 °

### Legende:

■ 00-033-0664 (*) - Hematit, syn - Fe203 - Y: 21.62 % - d x by: 1. - WL: 1.5406 - Rhombo.H.axes - a 5.03560 - b 5.03
   90.000 - gamma 120.000 - Primitive - R-3c (167) - 6 - 301.9
▼ 00-021-1276 (*) - Rutil, syn - Ti02 - Y: 8.94 % - d x by: 1. - WL: 1.5406 - Tetragonal - a 4.59330 - b 4.59330 - c 2.95
   90.000 - Primitive - P42/mnm (136) - 2 - 62.4344 - I/ Ic
►◄ 01-081-0463 (C) - Goethit, syn - FeO(OH) - Y: 34.21 % - d x by: 1. - WL: 1.5406 - Orthorhombic - a 4.61580- b 9.95
   90.000 - gamma 90.000- Primitive - Pbnm (62) - 4 - 138.915

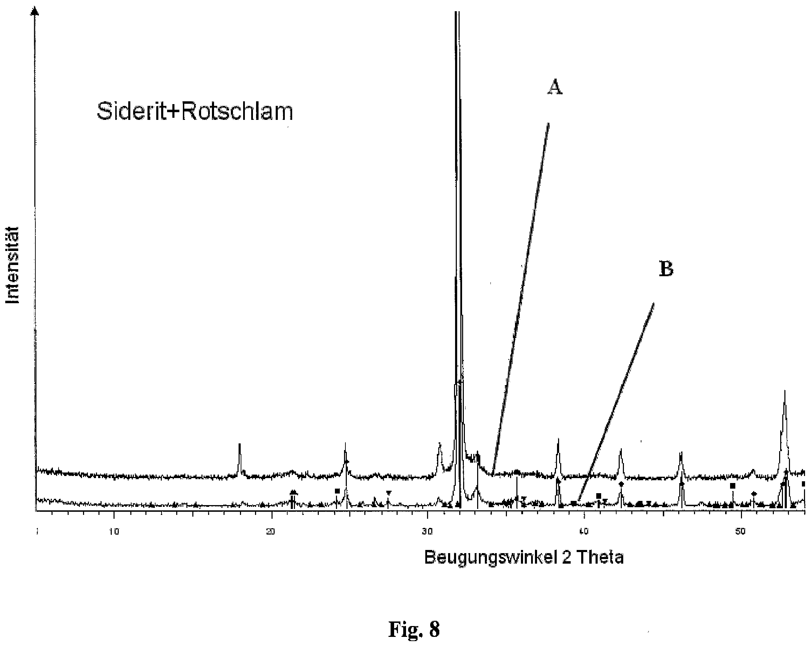

Figur 8 (Diagramm 3) zeigt das Röntgendiagramm von Rotschlamm, der in Richtung Siderit karbonisiert worden ist (vgl. DTA- und TG-Kurven Figur 4). Die Liniendiagramme zeigen:
Liniendiagramm A:
   Typ: 2Th/Th locked - Start: 5.000 °- End: 7
   Temp.: 25 °C (Room) - Time Started: 15 s
   °- Phi: 0.00 °- X: 0 Operations: Y Scale Add 1
Liniendiagramm B:
   Typ: 2Th/Th locked - Start: 5.000 °
   time: 10. s - Temp.: 25 °C (Room)
   °- Theta: 2.500 °- Chi: 0.00 °- Phi:
   Import

### Legende:

■ 00-033-0664 (*) - Hematit, syn - Fe2O3 - Y: 1.83 % - d x by: 1. - WL: 1.5406 - Rhombo.H.axes - a 5.03560 - b 5.03 90.000 - gamma 120.000 - Primitiv - R-3c (167) - 6 - 301 .926 - I/Ic PDF
◆ 01-083-1764 (C) - Siderit - Fe(CO3) - Y: 4.79 % - d x by: 1. - WL: 1.5406 - Rhombo.H.axes - a 4.691 60 - b 4.69160 90.000 - gamma 120.000 - Primitiv - R-3c (167) - 6 - 293.169 - I/Ic PDF 3.6
▲ 00-049-0007 (*) - Natriumaluminiumsilikat - Na1.15Al1.15Si0.8504 - Y: 0.53 % - d x by: 1. - WL: 1.5406 - Orthorhomb 10.21400 - alpha 90.000 - beta 90.000 - gamma 90.000 - Primitive - Pc21b (
▼ 00-021-1276 (*) - Rutil, syn - Ti02 - Y: 0.49 % - d x by: 1. - WL: 1.5406 - Tetragonal - a 4.59330 - b 4.59330 - c 2. gamma 90.000 - Primitiv - P42/mnm (136) - 2 - 62.4344 - I/Ic PDF 3.4 - F3

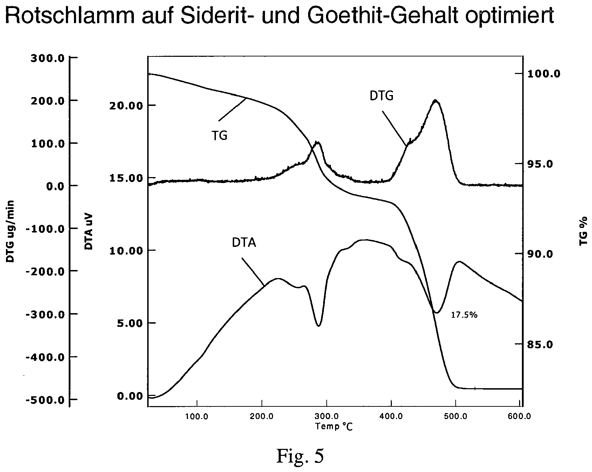

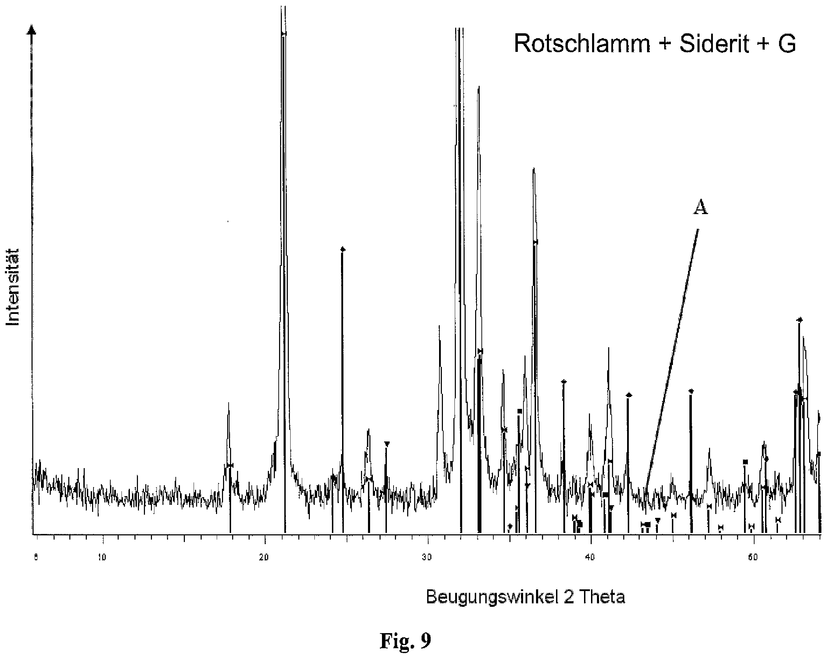

Figur 9 (Diagramm 4) zeigt das Röntgendiagramm von Rotschlamm, der sowohl in Richtung Siderit karbonisiert wie in Richtung Goethit rehydratisiert worden ist (vgl. DTA- und TG-Kurven Figur 5). Das Liniendiagramm zeigt:
Liniendiagramm A:
   33% Rotschlamm+33% Siderit+33% G
   End: 70.000 ° - Step: 0.040 °- Step ti
   14 s - 2-Theta: 5.000 ° - Theta Opera

### Legende:

■ 00-033-0664 (*) - Hematit, syn - Fe203- Y: 1.36 %,- d x by: 1. - WL: 1.5406-Rhombo.H.axes - a 5.03560- b 5.03560- c gamma 120.000- Primitiv - R 3c (167) -6- 301.926- I/Ic PDF
◆ 01-083-1764 (C) - Siderit - Fe(C03) - Y: 6.22 % - d x by: 1. - WL: 1.5406 - Rhombo.H.axes - a 4.691 60 - b 4.69160 - c 15 gamma 120.000 - Primitiv - R-3c (167) - 6 - 293.169 - I/Ic PDF 3.6
▼ 00-021-1276 (*) - Rutil, syn - Ti02 - Y: 0.69 % - d x by: 1. - WL: 1.5406 - Tetragonal - a 4.59330 - b 4.59330 - c 2.95920 90.000 - Primitive - P42/mnm (136) - 2 - 62.4344 - I/Ic PDF 3.4 - S
►◄ 01-081-0463 (C) - Goethit, syn - FeO(OH) - Y: 3.95 % - d x by: 1. - WL: 1.5406 - Orthorhombic - a 4.61580 - b 9.95450 - gamma 90.000 - Primitiv - Pbnm (62) - 4 - 138.91 5 - I/Ic PDF 2.

### Diskussion

Die Standardmethode zur qualitativen und quantitativen Bestimmung des Phasenbestandes von pulverförmigen Proben ist die Röntgenpulverdiffraktometrie. Sie ist eine vielseitig anwendbare, zerstörungsfreie Methode, die auch detaillierte Informationen über den atomaren Aufbau und die Kristallstruktur sowohl von natürlich vorkommenden, als auch synthetisch hergestellten Materialien liefern kann. Dabei zeigt jedes kristalline Material bei Beleuchtung mit Röntgenstrahlung ein einzigartiges und charakteristisches Beugungsmuster, das durch Größe, Symmetrie und atomaren Aufbau definiert ist und zur eindeutigen Identifikation herangezogen werden kann.

Unter dem Begriff "Thermische Analyse" werden Methoden zusammengefasst, die chemische und/oder physikalische Eigenschaften einer Verbindung als Funktion der Temperatur messen. Hierbei wird bei der Thermogravimetrie (TG) die Massenänderung einer Probe in Abhängigkeit von der Temperatur und/oder der Zeit gemessen. Dazu dient eine in das Messgerät integrierte Thermowaage. Hingegen nutzt die Differenz-Thermoanalyse (DTA) den charakteristischen Wärmeenergieumsatz bei einem Phasenübergang zur quantitativen und qualitativen Analyse. Hierbei wird die Temperatur der Probe mit der einer Referenzsubstanz verglichen.

Die Röntgendiagramme und die DTA- und TG-Kurven beweisen, dass Rotschlamm sowohl rehydratisiert wie auch karbonisiert werden kann. In allen Fällen wurde Rotschlamm verwendet, der beim Rohraufschluß (270 °C/60 bar) anfällt.

Bei der Karbonisierung entsteht hauptsächlich Siderit, bei der Rehydratisierung hauptsächlich Gibbsit/Boehmit und vor allem Goethit.

Bei der Herstellung dieser Produkte wurde Rotschlamm im ersten Schritt in saurer Lösung reduziert. Im zweiten Schritt wurde aus dieser Lösung unter oxidativ inerten Bedingungen durch Zusatz von NaHCO₃, Na₂CO₃ oder CaCO₃ Siderit ausgefällt. Soll in Richtung Gibbsit oder Goethit optimiert werden, werden durch Anhebung des pH-Wertes unter oxidierenden Bedingungen Goethit und Gibbsit ausgefällt.

Insgesamt und erfindungsgemäß können also aus Rotschlamm durch Rehydratisierung oder Karbonisierung OHFR-Systeme hergestellt werden, die im Bereich 210°C bis 310°C , bzw. 350°C bis 500°C ihre endotherme flammhemmende Wirkung entfalten.

Durch Hintereinanderschaltung von Karbonisierung und Rehydratisierung oder durch Mischung von karbonisierten und rehydratisiertem Rotschlamm können also maßgeschneiderte OHFR-Produkte für alle Typen von Kunststoffsystemen hergestellt werden sowohl im Niedrigtemperaturbereich als auch im Hochtemperaturbereich.

Aus den Figuren wird ersichtlich, wie sich modifizerter rehydratisierter oder modifizierter karbonisierter Rotschlamm, der entweder überwiegend in Richtung Gibbsit / Boehmit und Goethit / Lepidocrocit / Akaganeit oder überwiegend in Richtung Siderit modifiziert worden ist, thermisch zersetzt und in welchen Temperaturbereichen.

Aus den Hydroxiden bzw. den Oxidhydraten des Aluminiums und des Eisens entstehen hierbei die jeweiligen Oxide und Wasser, aus Eisen(II)carbonat entsteht das entsprechende Oxid und CO₂. Das entstehende CO₂ wirkt zusätzlich feuerlöschend.

Insbesondere Siderit zersetzt sich in einem Temperaturintervall, bei dem die Hydroxide und Oxidhydrate schon längst zersetzt sind und somit keinen effektiven Beitrag zum Flammschutz mehr leisten können.

Die deutlich höhere Zersetzungstemperatur von Siderit ist insofern vorteilhaft, als beim Test nach UL 94 Vertikal nach der kompletten Dehydratisierung der Hydroxide und Oxidhydrate der Brandvorgang wieder aufleben kann. Mit auf hohen Sideritgehalt optimiertem MKRS-HT steht somit für höhere Temperaturintervalle ein geeigneter OHFR-Flammhemmer zur Verfügung.

Insgesamt bietet sich die Möglichkeit ein FR-System zu entwickeln, bei dem durch geschickte Kombination von Niedertemperatur-OHFR-Agenzien, wie ATH oder Goethit, Lepidocrocit, Akaganeit, und Hochtemperatur-OHFR-Agenzien, wie vorzugsweise Eisen(II)carbonat, der erforderliche Flammschutz, respektive die systemimmanenten Brandausbreitung so gesteuert werden kann, daß für jedes Polymer- , respektive FR-Compound-System der optimale OHFR Effekt erreicht wird.

Mit modifiziertem rehydratisiertem Rotschlamm (MR2S-NT) und/oder karbonisierten Rotschlamm (MKRS-HT) lassen sich also "maßgeschneiderte" OHFR- Materialien zielgerichtet und hochspezifisch synthetisieren. Es ist auch möglich, durch Mischen von in Richtung MR2S-NT oder in Richtung MKRS-HT modifizierten Rotschlämmen solche Produkte für den Flammschutz herzustellen.

Die Wirkung kann noch durch die beschriebene Oberflächenmodifizierung und Kombination mit den beschriebenen Synergisten, insbesondere Nanoclays, intensiviert werden.

Grundsätzlich ist festzustellen, dass die Verarbeitungstemperatur der flammfest auszurüstenden Materialsysteme bestimmt, welche Produkte der modifizierte Rotschlamm enthalten soll. Im Bereich des Hochtemperaturflammschutzes sind Produkte für den Niedertemperaturflammschutz wie ATH, Goethit, Lepidocrocit und Akaganeit ungeeignet, da sich diese Produkte bereits bei der Verarbeitung zersetzen. Durch eine entsprechende Steuerung des Rehydratisierungsprozesses bzw. Karbonisierungsprozesses lassen sich erfindungsgemäß spezifisch und gezielt rehydratisierte und/oder karbonisierte Rotschlämme herstellen, die die gewünschten Bedingungen erfüllen. Grundsätzlich stören umgekehrt beim Niedertemperaturflammschutz die Produkte des Hochtemperaturflammschutzes nicht, da die Zersetzungstemperatur dieser Materialien weit über der Polymerverarbeitungstemperatur liegt. Es ist im Gegenteil vorteilhaft, da die Zersetzung des Siderit-optimierten MKRS-HT das Flammschutzpotential erheblich erhöht.

### Oberflächenmodifizierung :

Oberflächenmodifizierungen haben wesentlichen Einfluss auf die Qualität der FR-Systeme und auf ihre Verarbeitbarkeit bei der Compoundierung. Darüber hinaus unterstützen ausgewählte Oberflächenmodifizierungen den FR-Effekt und die Anbindung in der Interphase (Kompatibilisierungseffekt).

Folgende Rezepturen kommen beispielhaft für eine Oberflächenmodifizierung zum Einsatz:

### 1) Oberflächenmodifizierung A:

1 Gewichts% n-Aminopropyl-triethoxy-silan (AMEO) von Degussa / Evonik, bezogen auf die Gesamtmasse der Nicht-Polymerkomponenten

### 2) Oberflächenmodifizierung B:

1 Gewichts% EDENOR C 12/98-100 (Henkel, Deutschland),
1,5 Gewichts% SFR 100 (General Electric Silicones, Schenectady, NY, USA),
   bezogen auf die Gesamtmasse der Nicht-Polymerkomponenten

### 3) Oberflächenmodifizierung C:

| | |
|---|---|
| 2 Gewichts% | Trilene 66 (Uniroyal) (flüssiges EP(D)M Polymer), |
| 1 Gewichts% | Unichema 4900 (Stearic acid) Unichema, |
| 1 Gewichts% | Levapren 600 (EVA-Copolymer), |

bezogen auf die Gesamtmasse der Nicht-Polymerkomponenten

### 4) Oberflächenmodifizierung D:

1 Gewichts% Lithsolvent PL (Fa.Keller& Bohacek, Düsseldorf, Deutschland),
2 Gewichts% Epikote Resin 1163,
1 Gewichts% Edenor C 14 (Henkel),
bezogen auf die Gesamtmasse der Nicht-Polymerkomponenten

Für die Oberflächenmodifizierung wird ein Fluid- oder auch Turbinenmischer verwendet, der ein mehrstöckiges variables Werkzeug hat und dessen Außenmantel temperierbar ist.

Die Reaktionsadditive werden entweder zu Beginn des Mischzyklus mit dem zu modifizierenden Material in den stehenden oder in den langsam anlaufenden Turbomischer in den Misch-/Reaktionsraum dosiert. Wenn die Modifizierungsadditive flüssig bis pastös sein sollten, so werden diese in die Trombe des Mischers dosiert.

Nach Beendigung der Reaktion wird das heiße Material im nach geschalteten Kühlmischer schonend auf Raum- bzw. Absacktemperatur (typischerweise 35 °C bis 23 °C) herabgekühlt. Dieses Material wird pulvertechnologisch charakterisiert und danach in den unten beschriebenen Polymer-Compounds eingesetzt.

Die beschriebenen erfindungsgemäßen OHFR-Materialien sind beliebig lange haltbar und haben in den beschriebenen Modifikationen keinen chemisch erkennbaren Verfallszeitraum, sachgerechte trockene Lagerung in möglichst verschlossenen Original-Verpackungen vorausgesetzt. Durch die Korngrößenverteilung besteht nicht wie bei den aus einzelnen Komponenten vermengten FR-Kompositionen mit unterschiedlichen mittleren Korngrößenwerten (d50) die permanente Gefahr der partiellen oder totalen Entmischung durch z. B. Transportvorgänge oder beim Austrag aus dem Silo oder der Waage am Compoundieraggregat. Die zuvor beschriebenen erfindungsgemäßen OHFR -Materialien können bei den jeweiligen Compoundierungen wie sie sind, d.h. beispielsweise ohne Vortrocknung, eingesetzt werden. Speziell die oberflächenmodifizierten Varianten des erfindungsgemäßen OHFR-Materials nehmen keine Feuchtigkeit aus der Umgebungsluft auf und können somit unverändert/ohne Vortrocknung eingesetzt werden.

### Verarbeitungsverfahren der erfindungsgemäßen Materialien zu den in den Beispielen genannten OHFR-Compounds:

### Eingesetzte Versuchsmaterialien:

### Polymere

- EVA Copolymer "ESCORENE ULTRA UL 00119" von ExxonMobil
- PP Random Copolymer "VESTOLENE PP 8400"
- Polyamid 6 "ULTRAMID B3L" von BASF
- PVC DS 7060 von ICI UK

### Flammhemmer

- Aluminiumhydroxid "SUPERFINE SF4 ESD" von Alcan Chemicals Ltd. Burntisland, Scotland,UK (Nullprobe)
- Magnesiumhydroxid "Magnifin H 5" von Veitscher Magnesit Produktionsgesellschaft, Breitenau, Austria (Nullprobe)
- Pentabromdiphenylether p.a. und Antimontrioxid p.a. (Nullprobe)
- MR2S-NT (Nullproben)
- MKRS-HT (erfindungsgemäße Probe)
- MR2S-NT/MKRS-HT (erfindungsgemäße Probe)

### Additive/Synergisten

- Nanoclay: "Bentone 104" von Elementis Inc., USA oder "Nanofil SE 3000" von Südchemie / Rockwood Clay Additives GmbH, Deutschland
- Zinkstannat "FLAMTARD S" von Joseph Storey, UK

### Compoundieraggregate

Alle angeführten Polymercompounds wurden, wie in den jeweiligen Tabellen indiziert, auf den folgenden Compoundieraggregaten zu den entsprechenden Formmassen verarbeitet:
1) BUSS-Koaxial Kneter (MDK 46 E, 15 L/D mit GS 70 3,5 D) mit einem mittleren Durchsatz von 15 bis 20 kg / h
2) Gleichlaufender Zweiwellen(-schnecken)-Extruder (DSE oder SSE) Werner & Pfleiderer ZSK 25 mit einer mittleren Durchsatzleistung von 12 bis 25 kg/h oder Leistritz GL 50 mm mit 44 L/D mit einer mittleren Durchsatzleistung von 60 bis 250 kg/h.

### Dosierequipment

Gravimetrische Waagen (*Loss-in-weight feeder*) auf allen Aufgabestationen für Polymer, Additive / Stabilisatoren und OHFR-Agenzien sowohl im Haupteinzug (ELS 1 beim Buss-Ko-Kneter) als auch "downstream" wobei die Polymergranulat-Waage als Masterwaage fungiert.

Die OHFR-Agenzien werden im Split-Feed-Modus jeweils über die drei Dosierstationen verteilt in den Polymerstrom zudosiert.

Die in Form von Granulat vorliegenden Compounds werden anschließend sowohl mittels Spritzguß als auch mittels Extrusion zu den entsprechenden Prüfkörpern nach DIN / ISO und ASTM verarbeitet und anschließend getestet. Die Prüfkörper für den Test des spezifischen Durchgangswiderstand werden aus einem Walzfell-Rohling hergestellt durch Aufschmelzen des Granulats auf einer temperierten Labor-Doppelwalze in einer beheizten/kühlbaren Plattenpresse. Vor den jeweiligen Tests werden die fertigen Prüfkörper im Norm-Raumklima equilibriert.

**Prüfungen**

| | |
|---|---|
| Zugfestigkeit [MPa] DIN EN ISO 527 | (hier genannt ZF) |
| Zug-E-Modul [MPa] DIN EN ISO 527 | (hier genannt E-Mod) |
| Reißdehnung [m/m] DIN EN ISO 527 | (hier genannt EL) |
| Reißfestigkeit [MPa] DIN ISO 527 | (hier genannt RF) |
| Schlagzähigkeit [kg/qm] DIN EN ISO 8256 | (hier genannt a(n)) |
| Sauerstoffindex [%] DIN EN ISO 4589-2 | (hier genannt LOI) |
| Charpy-Schlagzähigkeit [kg/qm] DIN EN ISO 179 | (hier genannt a(k)) |
| UL 94 Vertikal nach IEC/DIN 60695-10/-11/-20 und CSA C 22.2 | |
| Cone-Calorimeter nach ISO 5660-1/ASTM E 1354 | |
| Spezifischer Durchgangswiderstand DIN ISO 53482 [Ω x cm] (hier genannt SDW) | |
| | |
| MFI (Melt-Flow-Index) bei X°(C) und Belastungsgewicht y (kg) | in (g/10 Minuten) |

Hier bei EVA /PE normalerweise 190°C bei 5 kg oder bei 10 kg für schwere fließende Polymere Bei PP normalerweise bei 230°C und 2,16 kg oder 5 kg Belastung für die schwerer fließenden Extrusionstypen

In Tabelle 4 werden beispielhaft die in Europa für Kabelcompounds/Kabelmäntel üblichen Minimalforderungen aufgeführt.

**Tabelle 4:**

| | |
|---|---|
| Rating der Leiter-Temperatur | 90°C |
| Zugfestigkeit | > 10 MPa |
| Reissdehnung | > 1,5 m/m (= 150%) |
| Wasseraufnahme | max. 5 % (24h bei 100°C) |

Generell lassen sich alle Varianten des erfindungsgemäßen OHFR-Materials auf allen Verarbeitungsmaschinen/Compoundieraggregaten, die in der (Kunststoff-)Industrie für die Herstellung (hoch)gefüllter Polymercompounds verwandt werden, herstellen, wie z. B. (Banbury-)Innenmischer; Doppelwalz-Werke; Innenmischer; Farrel Continuous Mixer (FCM); Planetwellen-Extruder; SSE (Single Screw Extruder) mit Schnecken, die eine effektive Homogenisierung ermöglichen (Maddox-Mischkopf, Sperr-Ringe); Intensiv-Mischer.

Infolge der hohen Schüttdichte (UTBD) sowohl der Niedertemperatur- als auch der Hochtemperaturvariante des modifizierten RS und der extrem guten Rieselfähigkeit lassen sich die Materialien exzellent sowohl mit konventionellem volumetrischen als auch (vorzugsweise) mit gravimetrischen Dosierequipment (sog. "loss-in-weight feeder" bsp. von K-Tron-Soder oder Brabender) in die Compoundiermaschine zugeben.

### Beispiele

### Beispiele für EVA:

### 0) Basisrezeptur als Nullprobe

**Rezeptur:**

| | |
|---|---|
| EVA 00119 | 40% |
| ATH | 60% |

**Ergebnisse:**

| | |
|---|---|
| ZF: | 8,9 |
| RF: | 6,5 |
| EL: | 1,8 |
| SDW: | E 13 |
| MFI (190/10): | 1,6 |
| UL 94 V(3,2 mm): | V-0 |
| LOI: | 28 |

### Kommentar:

Diese Rezeptur entspricht dem akzeptierten Standard innerhalb der Kabelindustrie und ist die Vergleichsbasis für die Beispiele im Polymersystem PE/EVA.

### 1)

**Rezeptur:**

| | |
|---|---|
| EVA | 40% |
| MKRS-HT | 60% |

**Ergebnisse:**

| | |
|---|---|
| ZF: | 9,8 |
| EL: | 1,6 |
| SDW: | E 14/ E 12 |
| UL 94 V (3,2mm): | (V-2)* |
| LOI: | 26 |
| MFI (190/10): | 1,4 |

| | |
|---|---|
| *: das Nachglühen ist zu lang, folglich ist die Einstufung nach UL 94 vertikal : n.e. (nicht erfüllt) | |

### Kommentar:

In dieser Rezeptur kommt ausschließlich der modifizierte karbonisierte RS (MKRS-HT) zum Einsatz. Die mechanischen Werte entsprechen dem Standard. Das Nachglühen kann durch Zusatz entsprechender Synergisten - wie z.B. Zinkstannat, Borate, etc. - unterdrückt werden.

### 2)

**Rezeptur:**

| | |
|---|---|
| EVA | 40% |
| MKRS -HT | 60%; oberflächenmodifiziert mit Beschichtung "D" |

**Ergebnisse:**

| | |
|---|---|
| ZF: | 14,4 |
| EL: | 1,5 |
| SDW: | E 15 / E 14 |
| UL 94 V (3,2 mm): | V-1 |
| LOI: | 29 |
| MFI (190/10): | 2,3 |

### Kommentar:

In dieser Rezeptur kommt ausschließlich modifizierter karbonisierter RS (MKRS-HT) zum Einsatz mit der Oberflächenmodifizierung nach Rezeptur "D". Die mechanischen Werte sind im Vergleich zum Standard sehr gut, die elektrischen Werte sind ebenfalls sehr gut, die Verarbeitbarkeit ist signifikant verbessert (um den Faktor 2). Der Flammschutz ist ebenfalls verbessert. Das Compound ist für sehr viele W&C Anwendungen verwendbar.

### 3)

**Rezeptur:**

| | |
|---|---|
| EVA | 35% |
| MR2S -NT | 30% |
| MKRS-HT | 30% |
| Nanoclay | 5% |

Die Mischung von MRRS und Nanoclay ist mit der Oberflächenmodifizierung "A" versehen.

**Ergebnisse:**

| | |
|---|---|
| ZF: | 16,6 |
| EL: | 3,41 |
| E-Mod. : | 189 |
| SDW: | E 15 / E 15 |
| UL 94 V (3,2,mm): | V-0 |
| LOI: | 28 |

### Kommentar:

In dieser Rezeptur kommt eine zielgerichtete Mischung aus modfiziertem rehydratisiertem RS (MR2S-NT) und modifiziertem karbonisierten RS (MKRS-HT), also ein modifizierter, karbonisierter und rehydratisierter Rotschlamm, mit der Oberflächenmodifizierung "A" zum Einsatz. Die mechanischen und elektrischen Werte sind sehr gut. Es zeigt einen hervorragenden Wert für den Spezifischen Durchgangswiderstand. Die Flammfestigkeit entspricht dem eines vergleichbaren ATH-flammgeschützten Compounds.

### 4)

**Rezeptur:**

| | |
|---|---|
| EVA | 40% |
| MKRS-HT | 26% |
| MDH | 26% |
| Nanoclay | 5% |
| Flamtard S | 3% |

Alle Nicht-Polymerkomponenten werden mit der Oberflächenmodifikation "C" versehen.

**Ergebnisse:**

| | |
|---|---|
| ZF: | 15 |
| EL: | 1,75 |
| SDW: | E 15 / E 14 |
| UL 94V(1,6 mm): | V-0 |
| | |
| LOI: | 49 |

### Kommentar:

In dieser Rezeptur wird modifizierter karbonisierter RS (MKRS-HT) in zielgerichteter Kombination mit einem konventionellen OHFR-Füllstoff (hier: MDH) eingesetzt in Kombination mit Synergisten (Nanoclay, Zinkstannat). Die mechanischen, elektrischen und FR-Eigenschaften sind im Vergleich zum aufgeführten Standard herausragend.

### 5)

**Rezeptur:**

| | |
|---|---|
| EVA | 55% |
| MKRS-HT nanoskalig | 18,5% |
| MDH | 18,5% |
| Nanoclay | 5% |
| Flamtard S | 3% |

Die Nicht-Polymerkomponenten sind mit der Oberflächenmodifizierung "B" versehen.

**Ergebnisse:**

| | |
|---|---|
| ZF: | 19,6 |
| EL: | 2,9 |
| SDW: | E 15 / E 15 |
| UL 94 V (1,6 mm): | V-0 |
| LOI: | 41 |

### Kommentar:

In dieser Rezeptur wird im Vergleich zur Rezeptur 4) eine verringerte Menge Flammschutzmittel (Kombination MKRS-HT nanoskalig mit MDH und Synergisten (Nanoclay und Flamtard S)) mit der Oberflächenmodifizierung nach Rezeptur "B" eingesetzt. Trotzdem werden Ergebnisse erreicht, die mit denen von Rezeptur 4) vergleichbar sind.

### Beispiele für PVC:

### 0) Basisrezeptur als Nullprobe

**Rezeptur:**

| | |
|---|---|
| PVC DS 7060 | 24,7 % |
| Plasticizer DIOP | 12,3 % |
| ATH Superfine SF4 ESD | 61,7 % |
| Irgastab EZ 712 | 1,3 % |

**Ergebnisse:**

| | |
|---|---|
| Time to Ignite (sec) | 34 |
| PHRR (KW/m2) | 118 |
| THR (MJ/m2) | 50,8 |
| Specific Extinct. Area (m2/kg) | 116,5 |
| Fire Performance Index (m2 s/KW) | 0,3 |
| Smoke Parameter (MW/kg) | 18,7 |

### Kommentar:

Diese Rezeptur ist der Vergleichsstandard für PVC-Formulierungen.

### 1)

**Rezeptur:**

| | |
|---|---|
| PVC DS 7060 | 24,7 % |
| Plasticizer DIOP | 12,3 % |
| MKRS-HT | 61,7 % |
| Irgastab EZ 712 | 1,3 % |

**Ergebnisse:**

| | |
|---|---|
| Time to Ignite (sec) | 69 |
| PHRR (KW/m2) | 106 |
| THR (MJ/m2) | 23,1 |
| Specific Extinct. Area (m2/kg) | 122,0 |
| Fire Performance Index (m2 s/KW) | 0,7 |
| Smoke Parameter (MW/kg) | 14 |

### Kommentar:

In dieser Rezeptur kommt modifizierter karbonisierter RS (MKRS-HT) zum Einsatz. Die Flammschutzwerte sind gegenüber dem ATH-basierenden Standard verbessert.

### Beispiele für PP:

### 0) Basisrezeptur als Nullprobe

**Rezeptur:**

| | |
|---|---|
| PP 8400 | 35% |
| MDH | 65% |

**Ergebnisse:**

| | |
|---|---|
| ZF: | 24,3 |
| RF: | 10,8 |
| EL: | 0,021 |
| E-Mod.: | 3400 |
| a(n): | 5,8 |
| UL 94V (3,2 mm): | V-0 |
| MFI (230 /5) : | 4,6 |

### Kommentar:

Diese Rezeptur ist der in der Kunststoffindustrie akzeptierte Vergleichsstandard auf Basis MDH.

### 1)

**Rezeptur:**

| | |
|---|---|
| PP 8400 | 35% |
| MKRS-HT | 65% |

**Ergebnisse:**

| | |
|---|---|
| ZF: | 17,5 |
| EL: | 0,23 |
| UL 94 V (3,2 mm): | V-2 |
| MFI (230/5): | 1,5 |

### Kommentar:

In dieser Formulierung kommt ausschließlich modifizierter karbonisierter Rotschlamm (MKRS-HT) zum Einsatz. Die Reißdehnung ist gegenüber der Nullprobe verbessert, der Flammschutz erreicht die dort angegebenen Werte niveaumäßig noch nicht.

### 2)

**Rezeptur:**

| | |
|---|---|
| PP 8400 | 35% |
| MKRS-HT | 60% |
| Nano | 5% |

Die Nicht-Polymerkomponmenten sind mit der Oberflächenmodifizierung "D" versehen.

**Ergebnisse:**

| | |
|---|---|
| ZF: | 19,1 |
| EL: | 0,56 |
| a(n): | o.Br(67) |
| UL 94 V (3,2 mm): | V-0 |
| MFI (230/5): | 6.1 |

### Kommentar:

In dieser Rezeptur kommt neben modifiziertem karbonisierten Rotschlamm (MKRS-HT) noch Nanoclay als Synergist sowie eine Oberflächenbeschichtung gemäß Rezeptur "D" zum Einsatz. Die mechanischen und die Flammfestigkeitswerte entsprechen dem Standard. Die Verarbeitbarkeit ist stark verbessert.

### Beispiele für Polypropylen mit Bromorganischem Flammschutz

### 0) Basisrezeptur als Nullprobe

**Rezeptur:**

| | |
|---|---|
| PP 8400 | 63% |
| Pentabromdiphenylether | 12% |
| Antimontrioxid | 5% |
| Mica | 20% |

**Ergebnisse:**

| | |
|---|---|
| ZF: | 23,6 |
| EL: | 0,023 |
| a(n) | 15,5 |
| UL 94 V(1,6 mm): | V-2 |
| MFI (230/5): | 7 |

### Kommentar:

Dies stellt eine polyolefinische FR-Formulierung dar, welche als Vergleichsprobe zu der nachfolgenden Rezeptur dient.

### 1)

**Rezeptur:**

| | |
|---|---|
| PP 8400 | 63% |
| Pentabromdiphenylether | 6% |
| Antimontrioxid | 2% |
| MKRS-HT | 29 |

**Ergebnisse:**

| | |
|---|---|
| ZF: | 25,8 |
| EL: | 0,17 |
| a(n) | ohne Bruch (o. Br.) |
| UL 94 V (1,6 mm): | V-0 |
| MFI (230/5): | 6 |

### Interpretation:

Bei einer Halbierung der Beladung an halogenorganischem/ Antimontrioxid- Flammschutz - System (in Prozent) ergibt der Einsatz des erfindungsgemäßen MKRS-HT an Stelle von Mica (Glimmer) ein Compound, das im Brandtest nach UL 94 Vertikal ein V-0 erreicht. Dazu sind die mechanischen Werte erheblich besser als die der Nullprobe.

### Beispiele für Polyamid:

### 0) Basisrezeptur als Nullprobe

**Rezeptur:**

| | |
|---|---|
| PA B3L | 45% |
| MDH (H-7) | 55% |

**Ergebnisse:**

| | |
|---|---|
| E-Mod.: | 5000 |
| ZF(RF): | 58 (58) |
| EL: | 0,023 |
| a(n) : | 21 |
| UL 94(3,2 mm): | V-0 |

### Kommentar:

Das PA B3L ist ein schlagzäh-modifiziertes Modell für ein weit verbreitetes "Engineering Plastic"-PA, welches u.a. in FR-Anwendungen wie FI-Schutzschaltungen verwendet wird.

Diese Rezeptur gilt in der entsprechenden Kunststoffindustrie als flammgeschützter Polyamid-Vergleichsstandard.

### 1)

**Rezeptur:**

| | |
|---|---|
| PA B3L | 45% |
| MKRS-HT | 55% |

**Ergebnisse:**

| | |
|---|---|
| ZF: | 55 |
| RF: | 55 |
| EL: | 0,018 |
| E-Mod: | 4520 |
| a(n): | 19 |
| UL 94 V (3,2 mm): | V-2 |

### Kommentar:

In dieser Rezeptur kommt modifizierter karbonisierter RS (MKRS-HT) zum Einsatz. Die mechanischen Werte entsprechen, der Flammwidrigkeitswert ist schlechter als der Standard.

### 2)

**Rezeptur:**

| | |
|---|---|
| PA B3L | 45% |
| MKRS-HT | 55% , versehen mit der Oberflächenmodifizierung A |

**Ergebnisse:**

| | |
|---|---|
| ZF (RF): | 65 (65) |
| EL: | 0,09 |
| E-Mod: | 5600 |
| a(n): | 32 |
| UL 94 V (3,2 mm): | V-1 ; (1,6 mm): n.e. |

### Kommentar:

In dieser Rezeptur kommt neben modifiziertem karbonisierten RS (MKRS-HT) eine Oberflächenmodifizierung nach der Rezeptur "A" zum Einsatz. Die Oberflächenmodifizierung A verbessert speziell die Flammfestigkeit des Compounds ganz erheblich, obwohl diese noch nicht das Niveau des Standards erreicht, aber schon erheblich besser ist als die in Rezeptur 1). Daneben verbessern sich auch die mechanischen Eigenschaften beträchtlich, was für technisch anspruchsvolle Anwendungen hilfreich ist.

### 3)

**Rezeptur:**

| | |
|---|---|
| PA B3L | 45% |
| MKRS-HT | 50% |
| Nanoclay | 5% |

Die Nicht-Polymerkomponenten sind mit der Oberflächenmodifizierung D versehen

**Ergebnisse:**

| | |
|---|---|
| ZF: | 63 |
| RF: | 63 |
| EL: | 0,29 |
| E-Mod: | 5500 |
| a(n): | 34 |
| UL 94 V (3,2 mm): | V-0 ;(1,6 mm): V-1 |

### Kommentar:

In dieser Rezeptur kommt neben modifiziertem karbonisierten Rotschlamm (MKRS-HT) der Synergist Nanoclay und die Oberflächenmodifizierung gemäß Rezeptur "D" zum Einsatz. Diese Compoundformulierung liefert eine hervorragende Flammfestigkeit, was eine Reduzierung der Wandstärke der elektrischen Bauteile erlaubt. Dabei erreichen die mechanischen Werte den Industrie-Standard.

### Diskussion

Aus Rotschlamm, der bei der Gewinnung von ATH aus Bauxit nach dem Bayer-Verfahren als Abfallprodukt entsteht, können durch Rehydratisierung und durch Karbonisierung hervorragende anorganische, halogenfreie Flammschutzmittel gewonnen werden. Rotschlamm zeigt auch ohne chemische Behandlung eine gewisse flammhemmende Wirkung, die auf Restgehalte von Gibbsit/Boehmit bzw. Goethit und andere synergistische Effekte im Rotschlamm zurückzuführen ist, aber insgesamt schwach und stark schwankend, also undefiniert sind. Erst durch Rehydratisierung und vor allem durch Karbonisierung von RS entstehen Flammhemmer mit definierten Eigenschaften.

Durch Rehydratisierung wird der Gehalt an Hydroxiden/Oxidhydraten des Aluminiums und Eisens erhöht. Diese Produkte entfalten ihre flammhemmende Wirkung zwischen ca. 220°C und 350°C. Durch Karbonisierung entsteht aus Rotschlamm vor allem Fe(II)carbonat, das seine flammhemmende Wirkung zwischen ca. 350°C und 500°C durch Zersetzung in Eisenoxid und CO₂ entwickelt.

Somit können Flammhemmer hergestellt werden, die entweder im Temperaturbereich zwischen 350°C bis 500°C wirken, also Hochtemperaturflammhemmer darstellen oder im Temperaturbereich zwischen 220°C und 350°C wirken, also Niedrigtemperaturbereichflammhemmer darstellen oder durch besondere Reaktionsführung oder durch Mischung sowohl den Niedrigtemperatur- wie auch Hochtemperaturbereich abdecken und damit zwischen 220°C und 500°C aktiv sind.

Zusammen mit den sonst noch im Rotschlamm vorhandenen Substanzen wie Silikate, Aluminiumsilikate, TiO₂, etc. die ebenfalls spezifisch oder synergistisch wirken, stehen damit neue, preisgünstige OHFR-Produkte zur Verfügung, die maßgeschneidert für jedes Polymer hergestellt werden können. Die bisher im Markt angebotenen Produkte sind ATH und MDH, die zwischen 180°C bis ca. 350°C wirken. ATH deckt den Bereich von 180°C bis ca. 220°C ab, MDH als sog. "Hochtemperaturflammhemmer" den Bereich bis 350°C. Die aus Rotschlamm durch Rehydratisierung bzw. erfindungsgemäß durch Karbonisierung gewonnenen Produkte decken mit einem einzigen Produkt Temperaturintervalle zwischen 220°C und 350°C, 350°C und 500°C bzw. 220°C und 500°C ab.

Die aus Rotschlamm hergestellten Produkte können sowohl physikalischen als auch chemischen Veränderungen unterworfen werden. Unter physikalischen Veränderungen wird insbesondere die Einstellung der mittleren Korngröße und die Restfeuchte verstanden. Zu den chemischen Veränderungen gehören die Einstellung des Anteils an "Na₂O-lösfich" (wasserlöslichem Natriumverbindungen) sowie Oberflächenbeschichtungen mit Substanzen wie z. B. Organosilane, Organotitanate, Organozirkonaluminate, Carbonsäuren, Hydroxy-Carbonsäurederivate, Weichmacher, Oligomere, Polymer-Precursors, Polymere, Ionomere, Borsäure und deren Metallsalzderivate, Zinkstannate, Zinkhydroxystannate oder Kombinationen hiervon. Weiterhin können diese Produkte mit Synergisten wie z. B. Organoclays (Nanoclays), Zinnverbindungen, Borsäure, Fluorpolymere (kleiner 5 %) etc. kombiniert sein.

In den Beispielen sind Tests mit folgenden Polymeren durchgeführt worden: EVA, PP, Polyamid 6 und PVC. Getestet wurde gegenüber ATH, MDH und Pentabromphenylether/Antimontrioxid als Nullproben. Als erfindungsgemäße Produkte kamen MKRS-HT oder MR2S-NT/MKRS-HT zum Einsatz.

### Folgende Ergebnisse konnten erzielt werden:

### EVA

Die in den Beispielen genannten Formulierungen ergaben Compounds, die sehr gute mechanische Werte, hervorragende Werte für den spezifischen Durchgangswiderstand und im Flammschutz vergleichbare Werte zu mit ATH ausgerüsteten Compounds ergaben. Die Compounds können in allen W & C Anwendungen eingesetzt werden.

### PVC

Die in Beispiel 1) aufgeführte Rezeptur ist in ihren Flammschutzwerten gegenüber dem ATH-basierenden Standard verbessert.

### PP

Die in Beispiel 2) aufgeführte Rezeptur entspricht in den mechanischen Werten und den Flammschutzwerten dem Standard.

Bei mit bromorganischem Flammschutz ausgerüstetem PP wurde in Rezeptur 1) gegenüber der Nullprobe die Menge an Pentabromdiphenylether/Antimonoxid halbiert und Mica (Glimmer) weggelassen. Dafür wurde MKRS-HT eingebaut. Diese Rezeptur zeigte bessere mechanische Eigenschaften und erreicht den Brandschutz UL 94 vertikal (VO).

### PA

Die in Beispiel 3) aufgeführte Formulierung erreicht in den mechanischen Werten den Standard. Die Flammfestigkeit ist hervorragend.

Insgesamt ist somit festzustellen, dass modifizierter, karbonisierter Rotschlamm (MKRS-HT) oder modifizierter, rehydratisierter Rotschlamm (MR2S-NT) oder Mischungen aus beiden z. B. durch spezielle Prozeßführung oder durch Mischen von MR2S-NT und MKRS-HT OHFR-Systeme ergibt, die in einem Produkt der bisher durch ATH und MDH abgedeckten Technologie entspricht. Erfindungsgemäß kommt nunmehr mit MKRS-HT ein zusätzliches Produkt in den Markt, das für den Hochtemperaturbereich (350°C - 500°C) bestens geeignet ist. Zusätzlich scheint die Rotschlamm -Matrix in die die durch Modifizierung hergestellten Produkte MR2S-NT und/oder MKRS-HT eingebettet sind, die Reaktionsintervalle, in denen Hydroxide/Oxidhydrate des Aluminiums und Eisens wirken, in höhere Temperaturbereiche zu verschieben.

Die Oberflächenmodifizierung der Siderit-optimierten MKRS-HT-Variante ergibt exzellentes Verhalten in der Wasserlagerung, d.h. es ist praktisch kein Abfall im Spezifischen Durchgangswiderstand zu beobachten. Dies ist für ein mineralisches Flammschutzmittel ein außergewöhnliches Ergebnis.

Generell ist festzustellen, dass mit modifiziertem, karbonisierten und/oder rehydratisiertem Rotschlamm, d.h. mit MKRS-HT oder MR2S-NT oder MKRS-HT/MR2S-NT für jeder Polymer maßgeschneiderte OHFR-Systeme gefunden werden können, die gegenüber bisher eingesetzten Produkten deutlich wirtschaftlicher sind, dabei aber vergleichbare Ergebnisse hinsichtlich mechanischer Werte und vor allem im Flammschutz erreichen. Diese OHFR-Systeme können auch mit denen im Markt befindlichen Produkten zur Erzielung oder Verdeutlichung spezieller Effekte gemischt werden, z. B. mit ATH, MDH, Brucit oder Huntit etc.

Erfindungsgemäß ist weiterhin festzustellen, dass Rotschlamm, modifizierter, rehydratisierter und karbonisierter Rotschlamm und Mischungen daraus in bestimmten Anwendungen Schwerspat ersetzten kann. Derartig ausgerüstete Produkte zeigen dann neben der "Schwerspat vergleichbaren Wirkung" zusätzlich eine flammhemmende Wirkung. Es liegt also eine Zweifachwirkung vor. Beispiele für solche Anwendungen sind z. B. Stoßstangen.

Erfindungsgemäß ist weiterhin festzustellen, dass Rotschlamm, modifizierter, rehydratisierter und karbonisierter Rotschlamm und Mischungen daraus eine schalldämmende Wirkung haben. Produkte, die damit ausgerüstet sind, zeigen also neben der flammhemmenden auch eine schalldämmende Wirkung. Auch hier liegt also eine Zweifachwirkung vor. Beispiele für solche Anwendungen sind insbesondere Kunststoffsysteme, die im Baubereich Anwendung finden.

Rotschlamm, modifizierter, rehydratisierter und karbonisierter Rotschlamm und Mischungen daraus können auch zum Zwecke der Schalldämmung mineralischen Stoffsystemen zugemischt werden. Beispiele sind hier Gipskartonplatten, Estriche, Beton, etc. Wichtige Anwendungen liegen insbesondere im Baubereich.

Überraschenderweise wurde herausgefunden, dass erfindungsgemäß modifizierter Rotschlamm gegenüber Baryt (Schwerspat) bei der Abschirmung von Radioaktivität und als Beschwerungsmittel für Bohrspülungen viele im nachfolgend aufgeführten Vorteile besitzt.

Eine weitere, zusätzliche hochinteressante Anwendung ergibt sich aus dem Wunsch ein ökologisch korrektes Substitut für Torf in sog. Anzucht- oder Blumenerde zu erlangen, welches gegen Winderosion (hohe Dichte!) und Austrocknung weitgehend resistent ist und auch nicht durch ubiquitäre Sporen schnell verschimmelt, was bei herkömmlichen Materialien ein permanentes Ärgernis darstellt und den Zuwachs an Bio-Masse beeinträchtigt.

Nachfolgend wird die Verwendung von modifiziertem Rotschlamm als Abschirmung gegen radioaktive Strahlung beschrieben. Auf Grund seiner hohen Dichte, die, wie bei der Anwendung als Beschwerungsmittel in Bohrschlamm-Anwendungen ausführlich beschrieben, noch gesteigert werden kann, kann der erfindungsgemäß modifizierte Rotschlamm in anderen, zur Zeit mit Baryt laufenden, Anwendungen verwendet werden. In der Literatur ist beschrieben, dass Eisenverbindungen insbesondere im Bereich der hochenergetischen ionisierenden Strahlung als Abschirmmedium sehr effektiv sind. Auch in (vorwiegend kommerziellen Siedewasser-) Reaktoren wird ein sogenannter "Eisenpanzer" als primäre Abschirmung, umgeben von einem zweiten Mantel aus Barytbeton und einem optionalen dritten "Schild", aus Strahlenschutzgründen eingesetzt. Schon seit längerem wird sowohl in Europa als auch in der Neuen Welt mit Hochdruck an einem Konzept für ein Endlager für hochradioaktive Abfälle aus im weitesten Sinne der Nuklear-Industrie (sowohl militärischer, energietechnischer als auch medizinischer Provenienz) geforscht. Dabei gibt es, vereinfachend gesagt, zwei Grundkonzepte:
a) Einlagerung in einem Salzstock;
b) Einlagerung im Granitgebirge.

Bei a) ging man von der eindeutig falschen Annahme aus, dass ein Salzstock sich a la Longe in der Erdgeschichte aufgelöst hätte, wenn es dort Wassereinbrüche z.B. durch den darüber liegenden "Gips-Dom" gäbe. Bedauerlicherweise ist dem nicht so.

Bei der Variante b) ist diese Gefahr ebenfalls vorhanden. Man muss sich in Folge dessen technisch praktikable und realisierbare Vorkehrungen überlegen, wie man, trotz eventuell möglicher Wassereinbrüche, verursacht durch tektonische Ereignisse, die Freisetzung radioaktiver Isotope, welche in das Grundwasser, falls wasserlöslich, migrieren könnten sowie die Emanation radioaktiver Gase (Radon, Krypton,...), die durch poröse Gesteinsformationen an die Oberfläche zu diffundieren in der Lage wären, mit hoher Wahrscheinlichkeit ausschließen kann.

Hierfür ist der erfindungsgemäße modifizierte Rotschlamm überraschenderweise höchst geeignet. Zur radiologischen Abschirmwirkung kommen folgende Eigenschaften:
- In Kombination mit sogenannten Nanoclays (Montmorillionite beispielsweise) bauen die Komposit-Systeme, die entweder als Pulvergemische oder als aus Pulver gepressten Formkörpern eingesetzt oder in wasser-absorbierenden sogenannten "Super-Adsorbant"- Polymersystemen (i.e. Polyacrylat-Derivate) compoundiert werden, bei Wasseraufnahme einen sehr hohen hydraulischen Druck im Gesamt-Lagersystem auf, der dem permanenten Wasserzutritt entgegenwirkt und das Gesamtsystem stabilisiert;
- Zusätzlich bewirkt die sehr hohe BET-Oberfläche eine Absorption freigesetzter Stoffe und insbesondere radioaktive Gase innerhalb des Endlagersystems und verhindert in Folge dessen die Freisetzung der Gefahrstoffe in die Biosphäre, sei es als lösliche Isotope im (Grund-) Wasser oder auch als radioaktive Gase in die Atmosphäre. Folglich sind die erfindungsgemäßen Verbindungen in mehreren Zubereitungssystemen dafür prädestiniert, in Endlagern für hoch radioaktive sowie mittel- bis niedrig- radioaktive Abfälle als Verfüllmaterial verwendet zu werden. Zu den vorgenannten Vorteilen derer Verwendung addiert sich der zusätzliche Vorteil, dass die erfindungsgemäßen Verbindung und deren Zubereitungen als Verfüll Material jederzeit "rückholbar" sind und einer späteren Verwendung des Endlagers als Wertstoff -"Mine" in keiner Weise im Wege stehen.
   Des Weiteren sind die erfindungsgemäßen Verbindungen und deren Zubereitungs-Systeme voll recyclebar und können im Ernstfall jederzeit ohne großen Aufwand von den Endlager-Kokillen , in denen der verglaste hochradioaktive Abfall inkorporiert ist, getrennt werden.

Weiterhin betrifft die Erfindung die Verwendung von modifiziertem Rotschlamm zur Abschwächung bzw. Abschirmung von elektromagnetischer Strahlung.

Mit Strahlung wird die freie Ausbreitung von Energie im Raum verstanden. Dabei unterscheidet man zwischen Teilchen- und elektromagnetische Strahlung. Erstere besteht aus geladenen oder ungeladenen Teilchen, die eine Masse besitzen und sich langsamer als Licht ausbreiten. Letztere auch Photonenstrahlung genannt besteht aus einem sich periodisch verändernden elektrischen und magnetischen Feld. Zu ihr zählen neben dem sichtbaren Licht, ultraviolette Strahlen und die Wärmestrahlung auch die Röntgen-, die Höhen und die Gammastrahlung. Elektromagnetische Strahlung wird durch Wellenlänge, Frequenz und Amplitude gekennzeichnet und ihre Ausbreitungsgeschwindigkeit beträgt im Vakuum ca. die Lichtgeschwindigkeit.

Tritt Photonenstrahlung auf Materie wird sie durch Absorption oder Streuung geschwächt. Die einer exponentielle Gesetzmäßigkeit folgende Schwächung der Strahlung ermöglicht eine theoretisch unendliche Reichweite der Strahlung. Dabei erfolgt die Schwächung durch Bildung von energiereichen Elektronen, die anschließend in Wechselwirkung mit anderen Atomen treten können (Photo-, Compton-Effekt, Paarbildung, klassische Streuung).

Das Maß der Schwächung ist generell von der Körperdichte, der Ordnungszahl der im Körper enthaltenen Atome und der Körperschichtdicke abhängig.

Teilchen- oder elektromagnetische Strahlung, die in der Lage ist, Elektronen aus Atomen oder Molekülen zu entfernen, sodass positiv geladene Ionen oder Molekülreste zurückbleiben, nennt man ionisierende Strahlung.

Die biologische Wirkung von ionisierender Strahlung auf Gewebe beruht auf Veränderungen von Makromolekulen, insbesondere von DNA, in den Zellen. Es können dabei direkte Strahlenschäden (stochastische und deterministische Strahlenschäden sowie teratogene Strahlenfolgen) oder indirekte Strahlenschäden (Bildung von schädigenden Radikalen) auftreten. Besonders Gewebe mit hohem Zellumsatz und hoher Proliferationsrate sind für Strahlenschäden anfällig.

Strahlenschutz wird in den meisten Ländern deshalb gesetzlich geregelt und regelt den Umgang mit ionisierender Strahlung zum Schutz der Bevölkerung und der beruflich exponierten Personen oder exponierten Patienten.

In diesem Zusammenhang wurde erfindungsgemäß festgestellt, dass die erfindungsgemäße Verbindung eine abschwächende und/oder abschirmende Wirkung auf elektromagnetischer Strahlung, insbesondere auf Röntgen- und/oder Gamma-Strahlung, aufweist.

In bestimmten vorteilhaften Ausführungsformen der erfindungsgemäßen Verwendung handelt es sich bei der elektromagnetischen Strahlung insbesondere um Röntgenstrahlung und/oder, Gamma-Strahlung.

In anderen vorteilhaften Ausführungsformen der Erfindung wird der erfindungsgemäße modifizierte Rotschlamm beispielsweise in bildgebenden medizinischen Geräten verwendet.

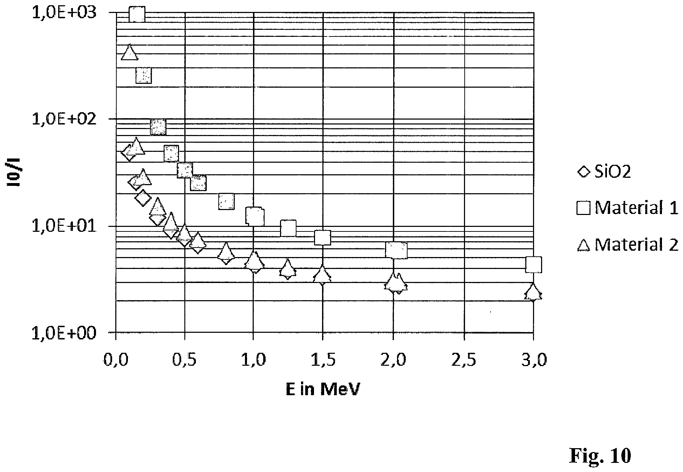

Figur 10 zeigt eine grafische Darstellung der Energieabhängigkeit der Schwächung I0/I bezüglich Gamma-Strahlung für verschiedene Materialien für eine Schichtdicke von d = 10 cm. Material 1 - Materialmix nach Tabelle 4; Material 2 - Eisen(II)carbonat. Zum Vergleich ist SiO2 in die Darstellung aufgenommen worden.

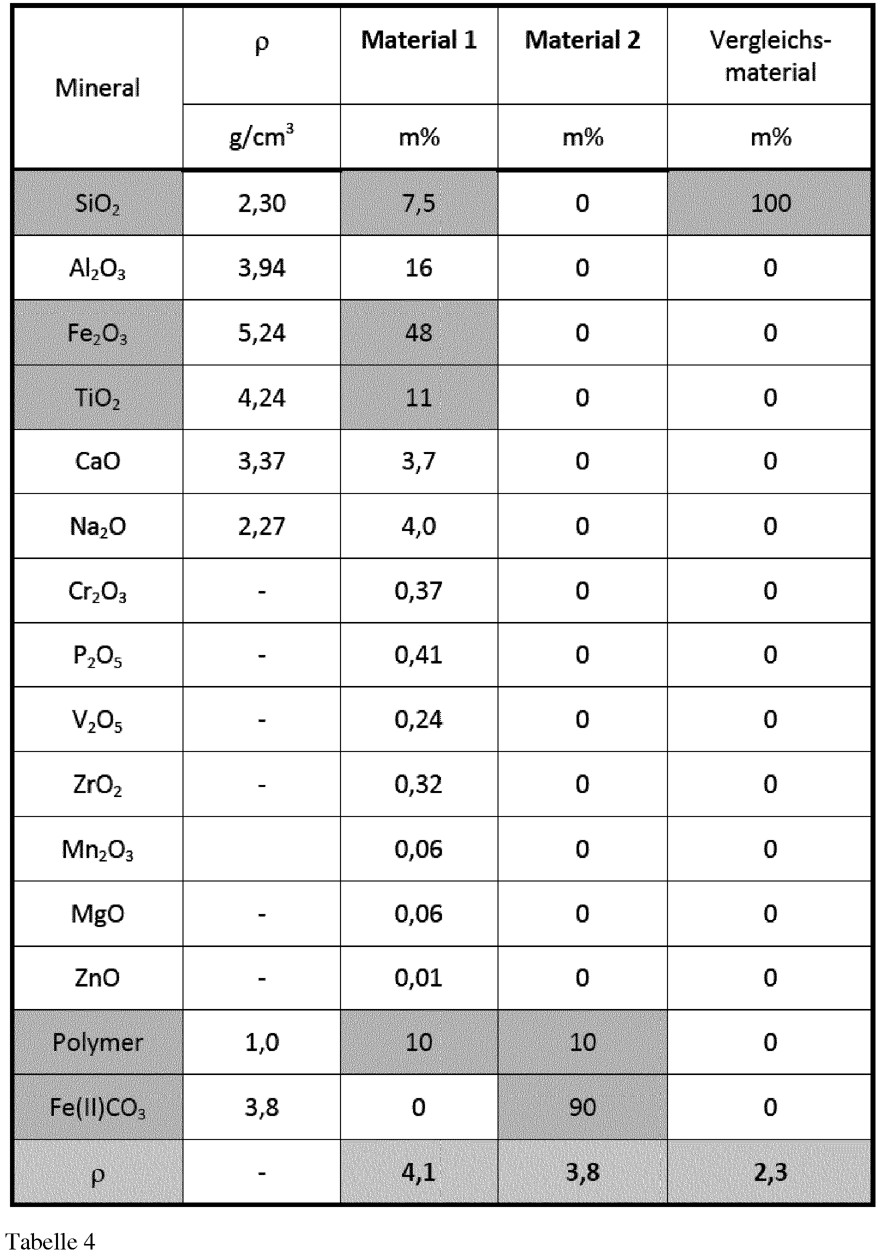

Tabelle 4 zeigt die Zusammensetzung (in Masse-% [m%]) der zu untersuchenden Materialien 1 und 2 und des Vergleichsmaterials SiO2. In der letzten Zeile ist eine berechnete Dichte der Materialmischung angegeben.

In der Figur 10 ist die x-Achse ist der gewählte Energiebereich zwischen 100 keV und 3 MeV. Auf der y-Achse ist das Verhältnis I0/I dargestellt, welches den Faktor ausdrückt, um den die Intensität der auf eine Absorber der Dicke d = 10 cm treffenden Gamma-Strahlung geschwächt wird. Im niederenergetischen Bereich um 200 keV ist die Schwächung sehr groß und beträgt für SiO2, Material 1 und 2 ca. 50, 50.000 und 500. Die Schwächung nimmt mit zunehmender Energie der Gamma-Strahlung ab. Generell kann festgestellt werden, dass die Abschirmwirkung des Materials 1 deutlich besser als dasjenige der beiden anderen Materialien ist.

Nachfolgend wird die Verwendung von modifiziertem Rotschlamm als Beschwerungsmittel für Bohrschlamm beschrieben.

Momentan wird hauptsächlich Baryt (Bariumsulfat) als Beschwerungsmittel in Bohrschlämmen wegen seiner Dichte von > 4,2 g/cm3 eingesetzt. Hierbei werden die im Baryt vorhandenen Begleitstoffe, oft Strontium und Quecksilberverbindungen, kritisch gesehen. Dazu kommt die Tatsache, dass später im Bohrverlauf Kalziumkarbonat trotz seiner relativ zum Baryt geringen Dichte als Beschwerungsmittel eingesetzt werden muss, um dessen Auflösung mit Säure zur Freimachung der Bohrlochwandung zu ermöglichen. Hierbei kommen die Vorteile des erfindungsgemäßen Materials zum Tragen. Durch die Reaktionsführung hin zu einem maximalen Gehalt der erfindungsgemäßen Verbindung an Eisen (II)Carbonat ist die Freimachung des Bohrloches durch Freisetzung des CO2 mit Säure später im Bohrprozess ein besonderer Vorteil. Hierbei bleibt der Vorteil der erfindungsgemäßen Verbindung, nämlich die hohe Dichte von > 4,5 g/cm3, erhalten. Hierdurch erübrigt sich der Einsatz von Kalziumcarbonat als sekundäres Beschwerungsmittel. Durch die herstellungsbedingte Kontrolle über die erfindungsgemäße Verbindung, kann die Umweltverträglichkeit gesichert werden. Da die erfindungsgemäße Verbindung magnetisch ist, ergeben sich ganz neue Möglichkeiten zur Separierung des Beschwerungsmittels vom "drilling fluid" Durch den Sinterprozess der erfindungsgemäßen Verbindung bei relativ niederen Temperaturen steigt die Dichte von etwa 3,7 g/cm3 auf bis zu > 4,5 g/cm3.

Das spezifische Gewicht des erfindungsgemäßen modifizierten Rotschlamms wird dadurch erhöht, indem er in einem langsam drehenden, direkt oder indirekt beheizten Drehrohr-Ofen in nicht- oxidierender Atmosphäre während einer Durchlaufzeit zwischen 1 und 2 Stunden auf eine Temperatur von mindestens 150°C und maximal auf eine Temperatur von 350°C erhitzt wird. Dabei wird z.B. der enthaltene Goethit (spez. Gewicht 4 - 4,1 g/cm3) zum Teil oder komplett in Hämatit (spez. Gewicht 4,9 -5,1 g/cm3) umgewandelt. Der gesteigerte Wert des spezifischen Gewichts des erfindungsgemäßen modifizierten Rotschlamms erlaubt die direkte Substitution von Schwerspat (Baryt) in Bohrspül-Flüssigkeitssystemen, wobei die Kornverteilung und die spezifische Oberfläche (nach BET) der erfindungsgemäßen Verbindungen nahezu unverändert erhalten bleiben. Mittels Micrometrics Gas-Pyknometer wird das spezifische Gewicht des erfindungsgemäßen modifizierten Rotschlamms 3,9 g/cm3 und das der in ihrem spezifischen Gewicht mittels des beschriebenen Prozesses erhöhten erfindungsgemäßen Verbindung 4,65 g/cm3 ermittelt. Ein typischer handelsüblicher Schwerspat (z.B. Fa. GWE Pumpenböse GmbH, Deutschland) als Beschwerungsmittel für Bohrspülungen hat, laut Datenblatt, das spezifische Gewicht von ca. 4,25 g/cm3.

Mittels Marsh Trichter wird die Tragfähigkeit der Bohrspülung als TAZ bestimmt.
In einem vergleichenden Test in einer Standard Bohrspülung (1 m3 Wasser + 30 kg Bentonit + Polymer + jeweiliges Beschwerungsmittel ; eingestellt auf die Dichte von 1,5kg/ L) zur Messung der AZ (Auslaufzeit) und der RAZ (Restauslaufzeit) ergab der Schwerspat eine AZ von 41 sec , eine RAZ von 32 sec, die in ihrem spezifischen Gewicht erhöhte erfindungsgemäße Verbindung eine AZ von 39 sec und eine RAZ von 29 sec.

Nachfolgend wird die Verwendung von modifiziertem Rotschlamm als ERDE- analog SUBSTRAT beschrieben.

Die heute oft verwandte Methode zum Anziehen von Pflanzen ist die Verwendung von Materialien, die mehr oder weniger Torf enthalten. Dies ist aus Gründen des Schutzes dieses Feuchtgebiet-Habitats sehr kritisch, da immer noch in Europa die stark gefährdeten Moore zur Torfgewinnung trockengelegt werden und mittlerweile sogar in Russland entsprechende Pläne umgesetzt zu werden drohen. Aus diesen Gründen ist die Verwendung von Torf-Substraten nicht nachhaltig und die zur Verfügung stehende Torfmenge wird zwangsläufig von Jahr zu Jahr geringer. Der Rohstoff Rotschlamm für die erfindungsgemäße Verbindung steht, weltweit gesehen, in Milliarden von Tonnen sozusagen als Abfall zur Verwendung bereit.
Der überraschend festgestellte Düngeeffekt des erfindungsgemäßen modifizierten Rotschlamms stellt einen weiteren Vorteil für die beschriebene Anwendung dar.

### Versuchsbeschreibung:

### a) Bodensubstrate

Boden der Jülicher Börde mit 95 Bodenpunkten (Zuckerrüben-Qualität)
Erfindungsgemäß modifizierter Rotschlamm
RS ex AOS-Stade, einmal gewaschen
Floratorf Anzuchterde (mit 25% Torf-Anteil)

### b) Pflanzgefäße

AquaGreen 100 cm von EMSA, mit Wasserreservoir

### c) Gießwasser

Vollentsalztes Wasser (Millipore-Qualität)

### d) Versuchspflanzen

| | |
|---|---|
| Pflücksalat | (Lactua sativa var. Crispa) |
| Päonien- Mohn | (Papaver somniferum ssp) |
| Quitte | (Cydonia oblonga) |

Versuchsdurchführung des Pflanzversuchs von Anfang 2011 bis Oktober 2013:
Die Pflanzversuche starten mit dem Einfüllen der Substrate in die Pflanzgefäße, wobei bis zur Höhe von 20 cm aufgefüllt wird. Es wird VE-Wasser in das untenliegende Wasserreservoir gefüllt, bis die Anzeige auf "voll" steht. Das Wasser wird regelmäßig kontrolliert und aufgefüllt. Dabei wird die nachgefüllte Wassermenge so bemessen, dass der volle Wasserstand wieder hergestellt ist. Je zwei Pflanzkästen werden mit derselben Pflanzenart bestückt und alle 3 Monate werden je eine Pflanze entnommen, visuell kontrolliert, die Wuchshöhe vermessen. Die Ausbildung des Feinwurzelgeflechts wird vergleichend begutachtet. Der Pflücksalat wird .wie auf der Sämerei-Tüte angegeben, in die Erde dosiert und zwar mit jeweils 15 cm seitlichem Abstand um das Ineinanderwachsen des Wurzelgeflechtes zwecks leichterer Begutachtung desselben zu vermeiden. Anschließend wird jeweils mit 200 mL VE-Wasser angegossen. Beim Päonien-Mohn wird jeweils ein Mohnkorn einen cm tief eingedrückt und dann mit 200 mL VE-Wasser angegossen. Die stratifizierten Quittensamen werden ebenfalls mit 15 cm Abstand einen cm tief in das jeweilige Substrat gegeben. Bei den Quittenpflanzen, die mehrjährig sind, wird ausschließlich die Wuchshöhe gemessen. Der Päonien-Mohn ist anderthalb-jährig und man erzielt beste Ergebnisse, wenn die Aussaat im Spätsommer des vorausgehenden Jahres erfolgt und die angelaufene Pflanze im Freien überwintert. Der Pflücksalat hat eine sechs- bis siebenmonatige Wachstumsperiode. Die Pflanzgefäße wurden im Freien im Halbschattenbereich mit der Orientierung Ost zu Südost aufgestellt und während des Versuches nicht bewegt. Aus den beigefügten Tabellen sind die gemessenen Werte für die jeweiligen Substrate und die drei Pflanzentypen ersichtlich.

### Ergebnis:

Die erfindungsgemäßen Verbindungen erweisen sich als die geeignetsten Substrate für die drei getesteten Pflanzentypen.

### 1. Versuch

**Pflücksalat (Lactua sativa var. Crispa)**

| | Zuckerrübenboden | AOS-RS einmalgewaschen | FLORATORF-Anzuchterde | Modifizierter Rotschlamm |
|---|---|---|---|---|
| Mai 2013 | ∼ 2 cm | ∼ 2 cm | ∼ 2 cm | ∼ 2 cm |
| Juni 2013 | ∼ 6 cm | ∼ 4 cm | ∼4 cm | ∼7 cm |
| July 2013 | ∼ 29 cm | ∼ 25 cm | ∼27 cm | ∼ 30 cm |
| August 2013 | ∼ 48 cm * | ∼ 35 cm * | ∼ 35 cm * | ∼ 60 cm * |
| September 2013 | ∼ 55 cm | ∼ 45 cm | ∼ 40 cm | ∼ 75 cm |
| Oktober 2013 | Ernte | Ernte | Ernte | Ernte |

Die Samen wurden schon Anfangs April gesetzt, trieben aber vermutlich auf Grund der kalten Witterung erst im Mai.

*: treiben sehr viele Seitenblätter am Strunk.

### 2. Versuch

**Quitte (Cydonia oblonga)**

| Anfang 2011 | Zuckerrüben-Boden | AOS-RS, gewaschen | FLORATORF-Anzuchterde | Modifizierter Rotschlamm |
|---|---|---|---|---|
| Juni 2012 | ∼ 10 cm | ∼ 8 cm | ∼ 7 cm | ∼ 12 cm |
| Oktober 2012 | ∼ 15 cm | ∼ 14 cm | ∼ 12 cm | ∼ 20 cm |
| April 2013 | ∼ 50 cm | ∼ 30 cm | ∼ 28 cm | ∼ 68 cm |
| Mai 2013 | ∼ 52 cm | ∼35 cm | ∼ 29 cm | ∼ 75 cm |
| Juni 2013 | ∼ 60 cm | ∼ 42 cm | ∼ 35 cm | ∼ 80 cm |
| July 2013 | ∼ 66 cm | ∼ 45 cm | ∼ 37 cm | ∼ 85 cm |
| August 2013 | ∼ 70 cm | ∼ 50 cm | ∼ 40 cm | ∼ 88 cm |
| September 2013 | ∼ 78 cm | ∼ 52 cm | ∼ 42 cm | ∼ 92 cm |
| Oktober 2013 | ∼ 83 cm | ∼ 58 cm | ∼ 44 cm | ∼ 100 cm |

Vom Gesamteindruck sind die Quittenbäumchen in der Zuckerrüben-Erde und dem modifizierten Rotschlamm am ausgewogensten gewachsen, was die Zahl der Zweige, Pflanzenhöhe und Blattzahl anbelangt.

### 3. Versuch

**Päonien Mohn (Papaver somniferum spp.)**

| | Zuckerrüben-Boden | AOS-RS, gewaschen | FLORATORF-Anzuchterde | Modifizierter Rotschlamm |
|---|---|---|---|---|
| August 2012 | ∼ 2,5 - 3 cm | ∼ 2- 2,5 cm | ∼ 1,8 - 2,2cm | ∼ 3cm |
| November 2012 | ∼12 - 15 cm | ∼11 - 13 cm | ∼10 cm | ∼ 15 - 18 cm |
| März 2013 | dito | dito | dito | dito |
| April 2013 | ∼ 45 cm | ∼ 32 cm | ∼ 28 cm | ∼ 50 cm |
| Mai 2013 | ∼ 75 cm | ∼70 cm | ∼ 53 - 55cm | ∼ 88 - 90 cm |
| Juni 2013 | ∼ 115 cm | ∼ 90 cm | ∼ 74 cm | ∼ 142 cm |
| July 2013 | ∼ 140 cm | ∼ 110 cm | ∼ 92 cm | ∼ 162 cm |
| "Blüte" | | | | |
| August 2013 | ∼ 155 cm | ∼ 128 cm | ∼ 106 cm | ∼ 178 cm |
| Durchschn. Ausbeute an Mohnsamen In mg | ∼ 1300 | ∼ 900 | ∼700 | ∼1600 |
| Erntehöhe der Pflanz. Im September 2013 (stehend vertrocknet) | 150 cm | 115 cm | 100 cm | **175 cm** |
| Kapsel-Durchmesser In mm | 40 - 42,5 | 30 - 32 | 19 - 22 | 43 -45 |

Die größten und am meisten gefüllten Blüten hatten die Pflanzen auf der Zuckerrüben-Erde und auf der Erfindungsgemäßen Verbindung, wobei die Farben von Weiß über Rosa und Dunkelrot bis Dunkelviolett variierten.

## Patentansprüche

1. Modifizierter, karbonisierter Rotschlamm mit einer mineralischen Zusammensetzung von
- 10 bis 50 Gewichtsprozent Eisenverbindungen,
- 12 bis 35 Gewichtsprozent Aluminiumverbindungen,
- 5 bis 17 Gewichtsprozent Siliziumverbindungen,
- 2 bis 10 Gewichtsprozent Titandioxid,
- 0,5 bis 6 Gewichtsprozent Calciumverbindungen und
- gegebenenfalls unvermeidbare Verunreinigungen,
**dadurch gekennzeichnet dass**,
das Gewichtsverhältnis von Fe(II)carbonat zu den Oxiden des Eisens mindestens 1 ist.

2. Modifizierter, karbonisierter Rotschlamm nach Anspruch 1, wobei der modifizierte, karbonisierte Rotschlamm ein modifizierter, karbonisierter und rehydratisierter Rotschlamm ist,
**dadurch gekennzeichnet dass**,
das Gewichtsverhältnis der Summe von Eisenhydroxid und Eisenoxidhydrat zu den Oxiden des Eisens mindestens 1 beträgt.

3. Modifizierter Rotschlamm nach Anspruch 1 oder Anspruch 2, wobei der Anteil an wasserlöslichem Natriumverbindungen, ausgedrückt als Gewichtsprozent Na₂O, nicht mehr als 0,03 beträgt und/oder
wobei die mittlere Teilchengröße (d50) nicht mehr als 50 µm, vorzugsweise 0,5 bis 10 µm bzw. 100 bis 900 nm beträgt, und/oder
wobei die Restfeuchte nicht mehr als 0,4 Gewichtsprozent beträgt.

4. Modifizierter Rotschlamm nach einem der Ansprüche 1 bis 3, wobei dessen Oberfläche mit mindestens einer Substanz versehen ist, welche die Verträglichkeit der Teilchen des modifizierten Rotschlamms mit einer Polymermatrix verbessert,
wobei die Substanz insbesondere ein Oberflächenmodifizierungsmittel ist, ausgewählt aus der Gruppe, bestehend aus Organosilanen, Organotitanaten, Organo-Zirkonaluminaten, Carbonsäurederivaten, Weichmachern, Oligomer- und Polymer-Vorstufen, Ionomeren, Borsäure und deren Metallsalze und Derivate, Zinkstannaten, Zinkhydroxystannaten oder Kombinationen hiervon, und/oder wobei dieser in Kombination mit Synergisten, insbesondere Organoclays (Nanoclays), Zinnverbindungen und Boraten, vorliegt.

5. Modifizierter Rotschlamm nach einem der Ansprüche 1 bis 4, wobei dieser ferner mindestens einen weiteren flammhemmenden Zusatz in einem Anteil bis zu 70 Gewichtsprozent enthält, wobei mindestens einer der weiteren flammhemmenden Zusätze eine endotherm reagierende Substanz ist, insbesondere eine endotherm reagierende Substanz, ausgewählt aus der Gruppe, bestehend aus Aluminiumhydroxid, Boehmit, Gibbsit, Goethit, Magnesiumhydroxid, Huntit, Brucit oder Mischungen hiervon.

6. Verwendung von modifiziertem Rotschlamm gemäß Anspruch 1 oder 2 und in Mischungen zusammen mit Rotschlamm als Füllstoff in Kunststoffsystemen anstelle von Schwerspat (BaSO4).

7. Verwendung von modifiziertem Rotschlamm gemäß Anspruch 1 oder 2 und Mischungen davon sowie mit Rotschlamm als Schalldämmer in Kunststoffsystemen.

8. Verwendung von modifiziertem Rotschlamm gemäß Anspruch 1 oder 2 und Mischungen davon sowie optional mit Rotschlamm als schalldämmender Zuschlagstoff in mineralischen Bausystemen wie z. B. Gipskartonplatten, Estrichen, Beton, etc.

9. Verwendung von modifiziertem karbonisierten Rotschlamm gemäß Anspruch 1 oder 2 und Mischungen davon sowie optional mit Rotschlamm zur Abschwächung bzw. Abschirmung von Strahlung, ausgewählt aus der Gruppe, bestehend aus elektromagnetischer Strahlung und Korpuskularstrahlung.

10. Verwendung nach Anspruch 9, wobei die Strahlung α-Strahlung, β-Strahlung, γ-Strahlung und/oder Neutronenstrahlung ist und/oder
wobei der modifiziertem Rotschlamm als solcher, insbesondere in Pulverform oder als Pressling bzw. Formkörper, verwendet wird oder
wobei der modifizierte Rotschlamm in Kombination mit mindestens einem weiteren Mittel, insbesondere in Kombination mit Beton oder in der Form eines Verbundwerkstoffes (Composite), verwendet wird und/oder
wobei der modifizierte Rotschlamm in einer Matrix, insbesondere einer thermoplastischen, duromeren und/oder elastomeren Matrix, insbesondere einer Kunststoff- bzw. Polymermatrix, vorliegt und/oder
wobei der modifizierte Rotschlamm in Kombination mit mindestens einem quellbaren Material, insbesondere mit einem Gehalt von 1 bis 50 Gew.-% bezogen auf die Gesamtmenge an modifiziertem Rotschlamm und quellbarem Material, verwendet wird, wobei das quellbare Material insbesondere ein Bentonit, insbesondere Montmorillonit, und/oder ein superabsorbierendes Polymer, insbesondere ein Poly(meth)acrylat, ist, wobei die Verwendung insbesondere zur Verminderung, insbesondere zur Verhinderung, des Eindringens von Wasser in Lagerstätten von strahlendem Material ist.

11. Verwendung von modifiziertem karbonisierten Rotschlamm gemäß Anspruch 1 oder 2 und Mischungen davon sowie optional mit Rotschlamm als Beschwerungsmittel in Bohrschlamm bzw. Bohrspülung.

12. Verwendung nach Anspruch 11, wobei der modifizierte Rotschlamm zur Erhöhung dessen spezifischen Gewichts thermisch behandelt wurde, insbesondere wobei der modifizierte Rotschlamm bei einer Temperatur von 150 bis 350°C thermisch behandelt wurde und/oder wobei das spezifische Gewicht des modifizierten Rotschlamms größer als 4 g/cm³, insbesondere größer als 4,5 g/cm³, vorzugsweise größer als 4,65 g/cm³, ist, und/oder wobei die spezifische Oberfläche des modifizierten Rotschlamms im Bereich von 2 bis 200 m²/g (gemessen nach BET) liegt, insbesondere von 10 bis 120 m²/g (gemessen nach BET) liegt, und/oder
wobei die Korngröße des modifizierten Rotschlamms kleiner als 10 mm ist, insbesondere im Bereich von 10 nm bis 6 mm liegt, und/oder
wobei die Schüttdichte (un-tamped bulk density, UTBD) des modifizierten Rotschlamms im Bereich von 100 g/L bis 3000 g/L liegt.

13. Verwendung von modifiziertem karbonisierten Rotschlamm gemäß Anspruch 1 oder 2 und Mischungen davon sowie optional mit Rotschlamm als Pflanzensubstrat bzw. als Düngemittel bzw. zur Förderung von Pflanzenwachstum.

14. Verwendung nach Anspruch 13, wobei der modifizierte Rotschlamm pulverförmig, granuliert und/oder als Formkörper vorliegt und/oder
wobei der Anteil des modifizierten Rotschlamms an dem gesamten Substrat im Bereich von 3 bis 100 Gew.-% liegt und/oder
wobei das Pflanzenwachstum um mindestens 25% gesteigert wird bzw. die Biomasse um mindestens 25% zunimmt und/oder
wobei die Verwendung zur Verbesserung der Ausbildung des Feinwurzelwerks einer Pflanze ist und/oder
wobei die Verwendung zur Erhöhung der Wasseraufnahmefähigkeit und/oder der Wasserhaltekraft (Wasserretention) ist, so dass insbesondere ein Austrocknen des Substrats verlangsamt wird.

15. Verwendung nach einem der vorhergehenden Ansprüche, wobei der modifizierte rehydratisierte Rotschlamm eine mineralische Zusammensetzung von
- 10 bis 50 Gewichtsprozent Eisenverbindungen,
- 12 bis 35 Gewichtsprozent Aluminiumverbindungen,
- 5 bis 17 Gewichtsprozent Siliziumverbindungen,
- 2 bis 21 Gewichtsprozent Ti02,
- 0,5 bis 6 Gewichtsprozent Calciumverbindungen, und
- gegebenenfalls unvermeidbare Verunreinigungen,
aufweist,
wobei die Verbindungen des Eisens einen Hydroxid- und Oxidhydratanteil von grösser/gleich 50 Gewichtsprozent, vorzugsweise grösser/gleich 80 Gewichtsprozent im Verhältnis zum Oxidanteil der Eisenverbindungen aufweisen, und wobei die Verbindungen des Aluminiums einen Hydroxidund Oxidhydratanteil von grösser/gleich 50 Gewichtsprozent, vorzugsweise grösser/gleich 80 Gewichtsprozent im Verhältnis zum Oxidanteil der Aluminiumverbindungen aufweisen.

## Claims

1. Modified, carbonised red mud with a mineral composition of
- 10 to 50 % by weight of iron compounds,
- 12 to 35 % by weight of aluminium compounds,
- 5 to 17 % by weight of silicon compounds,
- 2 to 10 % by weight of titanium dioxide,
- 0.5 to 6 % by weight of calcium compounds, and
possibly unavoidable impurities, **characterised in that** the weight ratio of Fe (II) carbonate to the oxides of iron is at least 1.

2. Modified, carbonised red mud according to claim 1, wherein the modified, carbonised red mud is a modified, carbonised and rehydrated red mud, **characterised in that** the weight ratio of the sum of iron hydroxide and iron oxide hydrate to the oxides of iron is at least 1.

3. Modified red mud according to claim 1 or claim 2, wherein the proportion of watersoluble sodium compounds, expressed in percentage by weight of Na₂O, is no more than 0.03 % by weight and/or wherein the average particle size (d50) is no more than 50 µm, is preferably 0.5 to 10 µm, or 100 to 900 nm, and/or wherein the residual moisture content is no more than 0.4 % by weight.

4. Modified red mud according to one of claims 1 to 3, wherein the surface thereof is provided with at least one substance which improves the compatibility of the particles of the modified red mud with a polymer matrix, wherein the substance is a surface modifying agent, selected from the group consisting of organosilanes, organotitanates, organo-zirconium aluminates, carboxylic acid derivatives, softeners, oligomer and polymer precursors, ionomers, boric acid and the metal salts and derivatives thereof, zinc stannates, zinc hydroxystannates or combinations thereof, and/or wherein said surface modifying agent is present combination with synergists, in particular organoclays (nanoclays), tin compounds and borates.

5. Modified red mud according to one of claims 1 to 4, wherein this also contains at least one further flame retardant additive in a proportion of up to 70 % by weight, wherein at least one of the further flame-retardant additives is an endothermally reacting substance, in particular an endothermally reacting substance selected from the group consisting of aluminium hydroxide, boehmite, gibbsite, goethite, magnesium hydroxide, huntite, brucite or mixtures thereof.

6. Use of modified red mud according to claim 1 or 2 and in mixtures together with red mud as filler in plastic systems instead of barite (BaSO4).

7. Use of modified red mud according to claim 1 or 2 and mixtures thereof and with red mud as sound insulator in plastic systems.

8. Use of modified red mud according to claim 1 or 2 and mixtures thereof with red mud as sound insulating additive in mineral building systems such as for example gypsum plasterboards, screeds, concrete, etc.

9. Use of modified carbonised red mud according to claim 1 or 2 and in mixtures thereof and optionally with red mud for attenuating or shielding radiation, selected from the group consisting of electromagnetic radiation and corpuscular radiation.

10. Use according to Claim 9, wherein the radiation is α-radiation, β-radiation, γ-radiation and/or neutron radiation and/or the modified red mud is used per se, in particular in powder form or as a pressed part or shaped body, or wherein the modified red mud is used in combination with at least one further agent, in particular in combination with concrete or in the form of a composite material (composite), and/or wherein the modified red mud is present in a matrix, in particular a thermoplastic, thermosetting or elastomeric matrix, in particular a plastic or polymer matrix, and/or wherein the modified red mud is used in combination with at least one swellable material, in particular with a content of 1 to 50 % by weight based on the total amount of modified red mud and swellable material, wherein the swellable material is in particular a bentonite, in particular montmorillonite, and/or a superabsorbent polymer, in particular a poly(meth)acrylate, wherein the use is in particular for reducing, in particular for preventing, the penetration from water into storage facilities for radiating material.

11. Use of modified carbonised red mud according to claim 1 or 2 and mixtures thereof and optionally with red mud as weighting material in drilling mud or drilling fluid.

12. Use according to claim 11, wherein the modified red mud has been thermally treated in order to increase the specific weight, in particular wherein the modified red mud has been thermally treated at a temperature of 150 to 350 °C and/or wherein the specific weight of the modified red mud is greater than 4 g/cm³, in particular greater than 4.5 g/cm³, preferably greater than 4.65 g/cm³, and/or wherein the specific surface area of the modified red mud is in the range from 2 to 200 m²/g (measured according to BET), in particular from 10 to 120 m²/g (measured according to BET), and/or wherein the particle size of the modified red mud is less than 10 mm, in particular in the range from 10 nm to 6 mm, and/or wherein the bulk density (un-tamped bulk density, UTBD) of the modified red mud is in the range from 100 g/L to 3000 g/L.

13. Use of modified carbonised red mud according to claim 1 or 2 and mixtures thereof and optionally with red mud as plant substrate or as fertiliser or for promoting plant growth.

14. Use according to claim 13, wherein the modified red mud is present in powdered form, in granular form and/or as a shaped body, and/or wherein the proportion of the modified red mud in the entire substrate is in the range from 3 to 100 % by weight, and/or wherein the plant growth is increased by at least 25 % or the biomass increases by at least 25 %, and/or wherein the use us for improving the formation of the network of fine roots of a plant, and/or wherein the use is for increasing the water absorption capacity and/or the water-retaining capacity (water retention), so that in particular drying out of the substrate is slowed down.

15. Use according to one of the preceding claims, wherein the modified rehydrated red mud has a mineral composition of
- 10 to 50 % by weight of iron compounds,
- 12 to 35 % by weight of aluminium compounds,
- 5 to 17 % by weight of silicon compounds,
- 2 to 21 % by weight of TiO₂,
- 0.5 to 6 % by weight of calcium compounds, and
possibly unavoidable impurities, wherein compounds of iron have a hydroxide and oxide hydrate fraction of greater than/equal to 50 % by weight, preferably greater than/equal to 80 % by weight in relation to the oxide fraction of the iron compounds, and wherein the compounds of aluminium have a hydroxide and oxide hydrate fraction of greater than/equal to 50 % by weight, preferably greater than/equal to 80 % by weight in relation to the oxide fraction of the aluminium compounds.

## Revendications

1. Boue rouge modifiée carbonisée présentant un composé minéral comprenant
- de 10 à 50 pourcent du poids de composés ferreux,
- de 12 à 35 pourcent du poids de composés d'aluminium,
- de 5 à 17 pourcent du poids de composés de silicium,
- de 2 à 10 pourcent du poids de dioxyde de titane,
- de 0,5 à 6 pourcent du poids de composés de calcium
- des impuretés inévitables le cas échéant,
**caractérisée en ce que**
le rapport en poids entre le carbonate de Fe(II) et les oxydes de fer est d'au moins 1.

2. La boue rouge modifiée carbonisée conformément à la Revendication 1 étant précisé que la boue rouge carbonisée est une boue rouge modifiée, carbonisée et réhydratée,
**caractérisée en ce que**
le rapport en poids entre la somme de l'hydroxyde de fer et de l'hydrate d'oxyde de fer et les oxydes de fer est d'au moins 1.

3. La boue rouge modifiée carbonisée conformément à la Revendication 1 ou à la Revendication 2 étant précisé que la teneur en composés de sodium, exprimé en pourcentage du poids de Na₂O, n'est pas supérieur à 0,03 et/ou
étant précisé que les particules moyennes (d50) ne mesurent pas plus de 50 µm, idéalement entre 0,5 µm et 10 µm, ou 100 à 900 Nm, et/ou
l'humidité résiduelle ne dépasse pas 0,4 pourcent du poids.

4. La boue rouge modifiée carbonisée conformément à l'une des Revendications 1 à 3 étant précisé que sa surface est dotée d'au moins une substance améliorant la compatibilité des particules de la boue rouge modifiée avec une matrice en polymère,
étant précisé que la substance est, en particulier, une substance de modification de la surface, sélectionnée parmi le groupe formé par les organosilanes, organotitanates, organo-aluminates de zirconium, dérivés d'acide carboxylique, adoucissants, pré-oligomères et pré-polymères, ionomères, acides boriques et leurs sels métalliques et dérivés, stannates de zinc, stannates d'hydroxydes de zinc ou combinaisons de ceux-ci, et/ou étant précisé qu'elle est en combinaison avec des synergistes, en particuliers des organoargiles (nanoclays), des composés d'étain et des borates.

5. La boue rouge modifiée carbonisée conformément à l'une des Revendications 1 à 4 étant précisé que celle-ci comporte, en outre, au moins un autre adjuvant ignifuge dans une proportion pouvant atteindre 70 pourcent du poids, étant précisé qu'au moins un des autres adjuvants ignifuges est une substance à réaction endothermique, en particulier une substance à réaction endothermique sélectionnée dans groupe formé par l'hydroxyde d'aluminium, la boehmite, la gibbsite, la goethite, l'hydroxyde de magnésium, la huntite, la brucite ou un mélange de ceux-ci.

6. Utilisation de la boue rouge modifiée conformément à la Revendication 1 ou 2 et dans des mélanges comprenant de la boue rouge comme matière de remplissage dans des systèmes en matière plastique à la place du sulfate de baryum (BaSO4).

7. Utilisation de la boue rouge modifiée conformément à la Revendication 1 ou 2 et des mélanges la comprenant, ainsi qu'en combinaison avec de la boue rouge comme isolant phonique dans des systèmes en matière plastique.

8. Utilisation de la boue rouge modifiée conformément à la Revendication 1 ou 2 et des mélanges la comprenant, ainsi qu'optionnellement en combinaison avec de la roue rouge comme isolant phonique dans des systèmes minéraux comme, par exemple, les plaques de plâtre, les chapes, le béton, etc.

9. Utilisation de la boue rouge modifiée carbonisée conformément à la Revendication 1 ou 2 et des mélanges la comprenant, ainsi qu'optionnellement en combinaison avec de la boue rouge utilisée comme atténuation des rayonnements ou protection contre les rayonnements sélectionnés dans le groupe comprenant des rayons électromagnétiques et corpusculaires.

10. Utilisation conformément à la Revendication 9 étant précisé que le rayon est un rayon α, un rayon β, un rayon γ et/ou des rayonnements neutroniques, et/ou
étant précisé que la boue rouge modifiée est utilisée en tant que telle, en particulier sous forme de poudre ou sous forme de pièce pressée ou de corps moulé ou
étant précisé que la boue rouge modifiée est utilisée en combinaison avec au moins un autre produit, en particulier en combinaison avec le béton ou sous la forme d'un matériau composite, et/ou
étant précisé que la boue rouge modifiée est présente dans une matrice, en particulier une matrice thermoplastique duromère et/ou élastomère, en particulier une matrice plastique ou polymère, et/ou
étant précisé que la boue rouge modifiée est utilisée en combinaison avec au moins un matériau susceptible de gonfler, en particulier avec une teneur de 1 à 50 pourcent du poids par rapport à la quantité totale de boue rouge modifiée et de matériau susceptible de gonfler, étant précisé que le matériau susceptible de gonfler est, en particulier, de la bentonite, en particulier de la montmorillonite, et/ou un polymère super-absorbant, en particulier un poly(méth)acrylate, étant précisé que l'utilisation est prévue pour la réduction, et plus particulièrement pour la prévention de la pénétration d'eau dans les centres de stockage de matériel radioactif.

11. Utilisation de boue rouge modifiée carbonisée conformément à la Revendication 1 ou 2 et de mélanges la comprenant, ainsi qu'optionnellement en combinaison avec de la boue rouge comme agent alourdissant dans des boues de forage ou des fluides de forage.

12. Utilisation conformément à la Revendication 11, étant précisé que la boue rouge modifiée a été soumise à un traitement thermique afin d'augmenter son poids spécifique, étant précisé en particulier que la boue rouge a été soumise à un traitement thermique à une température comprise entre 150 et 350°C et/ou étant précisé que le poids spécifique de la boue rouge modifiée est supérieur à 4g/cm³, en particulier supérieur à 4,5 g/cm³, de préférence supérieur à 4,65 g/cm³, et/ou étant précisé que la surface spécifique de la boue rouge modifiée est comprise dans une fourchette comprise entre 2 et 200 m²/g (mesure BET), en particulier entre 10 et 120 m²/g (mesure BET), et/ou
étant précisé que la granulométrie de la boue rouge modifiée est inférieure à 10 mm, en particulier comprise dans une fourchette entre 10 nm et 6 mm, et/ou
étant précisé que la masse volumétrique non tassée (untamped bulk density, UTBD) de la boue rouge modifiée est comprise dans la fourchette entre 100 g/l et 3 000 g/l.

13. Utilisation de boue rouge modifiée carbonisée conformément à la Revendication 1 ou 2 et de mélanges la comprenant, ainsi qu'optionnellement en combinaison avec de la boue rouge comme substrat minéral ou fertilisant pour la stimulation de la croissance des plantes.

14. Utilisation conformément à la Revendication 13, étant précisé que la boue rouge modifiée présente la forme de poudre, granules et/ou corps moulés et/ou
étant précisé que la teneur en boue modifiée du substrat total est comprise dans une fourchette entre 3 et 100 pourcent du poids et/ou
étant précisé que la croissance des plantes est augmentée d'au moins 25 pourcent ou que la biomasse augmente d'au moins 25 pourcent et/ou
étant précisé que l'utilisation vise l'augmentation de la capacité d'absorption d'eau et/ou de rétention d'eau, de sorte à ralentir l'assèchement du substrat.

15. Utilisation conformément à l'une précédente des Revendications étant précisé que la boue rouge modifiée réhydratée est un composé minéral comprenant
- de 10 à 50 pourcent du poids de composés ferreux,
- de 12 à 35 pourcent du poids de composés d'aluminium,
- de 5 à 17 pourcent du poids de composés de silicium,
- de 2 à 21 pourcent du poids de TiO2,
- de 0,5 à 6 pourcent du poids de composés de calcium
- des impuretés inévitables le cas échéant,
étant précisé que les composés de fer présentent une teneur en hydroxydes et d'hydrates d'oxyde supérieure/égale à 50 pourcent du poids, de préférence supérieure/égale à 80 pourcent du poids par rapport à la teneur en oxydes des composés de fer, et étant précisé que les composés d'aluminium présentent une teneur en hydroxydes et d'hydrates d'oxyde supérieure/égale à 50 pourcent du poids, de préférence supérieure/égale à 80 pourcent du poids par rapport à la teneur en oxydes des composés d'aluminium.
